(19) Europäisches Patentamt
European Patent Office
Office européen des brevets

(11) EP 3 144 986 A1

(12) EUROPEAN PATENT APPLICATION
published in accordance with Art. 153(4) EPC

(43) Date of publication:
**22.03.2017 Bulletin 2017/12**

(21) Application number: **15792483.8**

(22) Date of filing: **13.05.2015**

(51) Int Cl.:
***H01L 35/08*** *(2006.01)* ***C22C 5/06*** *(2006.01)*
***C22C 29/18*** *(2006.01)* ***H01B 1/22*** *(2006.01)*
***H01L 35/14*** *(2006.01)* ***H01L 35/34*** *(2006.01)*
***H02N 11/00*** *(2006.01)*

(86) International application number:
**PCT/JP2015/063791**

(87) International publication number:
**WO 2015/174462 (19.11.2015 Gazette 2015/46)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **16.05.2014 JP 2014102234**

(71) Applicant: **National Institute of Advanced Industrial Science and Technology**
**Tokyo 100-8921 (JP)**

(72) Inventor: **FUNAHASHI, Ryoji**
**Ikeda-shi**
**Osaka 563-8577 (JP)**

(74) Representative: **Patentanwälte Gierlich & Pischitzis**
**Partnerschaft mbB**
**Gerbermühlstraße 11**
**60594 Frankfurt am Main (DE)**

# (54) THERMOELECTRIC CONVERSION ELEMENT AND THERMOELECTRIC CONVERSION MODULE

(57) A thermoelectric conversion element in which one end of an n-type thermoelectric conversion material and one end of a p-type thermoelectric conversion material are each bonded to a conductive substrate using a bonding agent, the n-type thermoelectric conversion material and the p-type thermoelectric conversion material being specific silicides, the bonding agent being a conductive paste containing conductive metals consisting of silver and at least one noble metal selected from the group consisting of gold, platinum, and palladium, as well as a thermoelectric conversion module comprising a plurality of these thermoelectric conversion elements and having a specific structure, achieve excellent thermoelectric conversion performance in an intermediate temperature range of room temperature to about 700°C, and performance degradation hardly occurs even when electric generation is repeated, making it possible to maintain the excellent performance over a long period of time.

FIG. 1

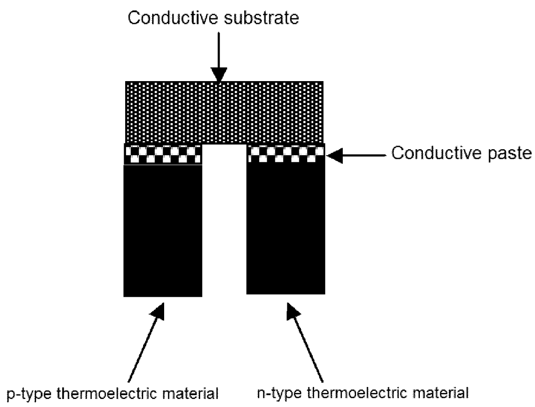


EP 3 144 986 A1

## Description

Technical Field

The present invention relates to a thermoelectric conversion element and a thermoelectric conversion module.

Background Art

In Japan, the yield of effective energy obtained from the primary energy supply is only about 30%, and about 70% of the energy is discarded as heat into the atmosphere. In addition, the heat generated by combustion, for example, in factories or garbage incineration plants is also released into the atmosphere without being converted to other energy. In this manner, humankind wastes a vast amount of heat energy, and obtains only a small amount of energy from activities such as combustion of fossil energy.

To increase the yield of energy, it is effective to use the heat energy released into the atmosphere. Thermoelectric conversion, in which heat energy is directly converted to electrical energy, is considered an effective means for that purpose. Thermoelectric conversion, which uses the Seebeck effect, is an energy conversion technique for generating electricity by creating a temperature difference between both ends of thermoelectric conversion materials to thereby produce a potential difference.

In such electric generation that uses thermoelectric conversion, i.e., thermoelectric generation, electricity is obtained by simply placing one end of a thermoelectric conversion material at a portion heated to a high temperature by waste heat, placing the other end thereof in the air or at a portion cooled to a low temperature with water, and connecting an external resistance to both ends thereof. This technique does not require any mobile equipment, such as a motor or a turbine, that is necessary for general electricity generation. Thus, the technique enables continuous generation of electricity at low cost for a long period of time without emitting combustion gas or the like, until the thermoelectric conversion module is degraded. Further, thermoelectric generation can generate electricity at a high-output density, and it is thus possible to downsize an electricity generator (module) itself while reducing its weight for use as a mobile power source for cellular phones and notebook computers.

As stated above, thermoelectric generation is expected to be a promising technology that plays a part in resolving energy problems, which is a future concern. However, to enable thermoelectric generation, there is a need for a thermoelectric conversion module constructed with thermoelectric conversion materials with high thermoelectric conversion efficiency, thermal resistance, chemical durability, and the like.

$CoO_2$-based layered oxides such as $Ca_3Co_4O_9$ have been reported as materials that exhibit excellent thermoelectric performance in air at high temperatures (see Non-patent Literature 1 below). Silicides, such as $Mn_3Si_4Al_2$, have also been reported as materials that exhibit excellent thermoelectric performance in air, as well as excellent oxidation resistance, in an intermediate temperature range of room temperature to about 700°C (see, for example, Patent Literature 1 and Patent Literature 2). Accordingly, the development of thermoelectric conversion materials has been progressing.

Achieving efficient thermoelectric generation using such thermoelectric conversion materials requires a thermoelectric conversion element obtained by connecting a pair of a p-type thermoelectric conversion material (see, for example, Non-patent Literature 2) and an n-type thermoelectric conversion material (see, for example, Non-patent Literature 3), as well as a thermoelectric generation module, i.e., an electric generator, in which these thermoelectric conversion elements are integrated. However, the development of thermoelectric conversion elements and thermoelectric generation modules is currently lagging behind, compared to the development of thermoelectric conversion materials themselves.

Of the thermoelectric conversion materials stated above, those consisting of a silicide show excellent thermoelectric conversion performance in an intermediate temperature range of room temperature to about 700°C. To put a thermoelectric generation module into practical use by using these materials, it is important to develop a technique that enables low-resistance connection of the thermoelectric conversion materials. Soldering is known as a typical bonding agent. However, thermoelectric generation performed using waste heat having a temperature as high as 400°C or higher would cause oxidation, melting, and the like if the thermoelectric conversion materials are bonded by soldering. For this reason, a silver paste is mainly used as a bonding material (see, for example, Non-patent Literature 4). However, if a silver paste is used to bond thermoelectric conversion materials formed of a silicide to a conductive substrate, the silver element diffuses into the thermoelectric conversion materials as electric generation is repeated, causing problematic degradation of the electric generation performance with time.

Citation List

Patent Literature

PTL 1: JP2012-124243
PTL 2: JP2014-049737

Non-patent Literature

NPL 1: R. Funahashi et al., Jpn. J. Appl. Phys. 39, L1127 (2000)
NPL 2: Thermoelectric properties of Bi2Sr2Co2Ox polycrystalline materials, R. Funahashi, I. Matsubara, and S. Sodeoka, Applied Physics Letters, Vol. 76, No. 17, pp. 2385-2387 (2000)
NPL 3: Thermoelectric properties of n-type Mn3-xCrxSi4Al2 in air, R. Funahashi, Y. Matsumura, H. Tanaka, T. Takeuchi, W. Norimatsu, E. Combe, R.O. Suzuki, Y. Wang, C. Wan, S. Katsuyama, M. Kusunoki, and K. Koumoto, J. Appl. Phys. Vol. 112, 073713 (2012)
NPL 4: A portable thermoelectric-power-generating module composed of oxide devices, R. Funahashi, M. Mikami, T. Mihara, S. Urata, and N. Ando, Journal of Applied Physics, Vol. 99, No. 6, 066117 (2006)

Summary of Invention

Technical Problem

The present invention has been accomplished in view of the aforementioned problems in known art techniques. A primary object of the present invention is to provide a novel thermoelectric conversion element and a thermoelectric conversion module that are capable of exerting excellent thermoelectric conversion performance in an intermediate temperature range of room temperature to about 700°C, and maintaining the excellent performance for a long period of time with almost no performance degradation, even when electric generation is repeated.

Solution to Problem

The present inventor conducted extensive research to achieve the above object, and found that when specific silicides that are capable of exerting excellent performance in an intermediate temperature range are selected for use as a p-type thermoelectric conversion material and an n-type thermoelectric conversion material, and when a paste containing, as conductive metals, silver and at least one noble metal selected from the group consisting of gold, platinum, and palladium is used as a bonding agent to bond these thermoelectric conversion materials to a conductive substrate, appropriate conductivity is imparted to the joints of the thermoelectric conversion materials. The present inventor also found that even when electric generation is repeatedly performed in an intermediate temperature range, excellent bonding strength is maintained, and the silver contained in the conductive paste is prevented from diffusing into the thermoelectric conversion materials, maintaining excellent thermoelectric conversion performance for a long period of time. The present invention has been accomplished based on such findings.
More specifically, the present invention provides the following thermoelectric conversion element and thermoelectric conversion module.

Item 1. A thermoelectric conversion element wherein one end of an n-type thermoelectric conversion material and one end of a p-type thermoelectric conversion material are each bonded to a conductive substrate using a bonding agent,
wherein

(1) the n-type thermoelectric conversion material is a silicide of the following item (a) or (b):

(a) a silicide represented by the compositional formula:

$$Mn_{3-x1}M^1_{x1}Si_{y1}Al_{z1}M^2_{a1},$$

wherein $M^1$ is at least one element selected from the group consisting of Ti, V, Cr, Fe, Co, Ni, and Cu, $M^2$ is at least one element selected from the group consisting of B, P, Ga, Ge, Sn, and Bi,

$$0 \leq x1 \leq 3.0,$$

$$3.5 \leq y1 \leq 4.5,$$

$$2.0 \leq z1 \leq 3.5,$$

and

$$0 \leq a1 \leq 1,$$

the silicide having a negative Seebeck coefficient at a temperature of 25°C or higher; or

(b) a silicide represented by the compositional formula:

$Mn_{x2}M^3_{y2}Si_{m2}Al_{n2}$,

wherein $M^3$ is at least one element selected from the group consisting of Ti, V, Cr, Fe, Co, Ni, and Cu,

$$2.0 \leq x2 \leq 3.5,$$

$$0 \leq y2 \leq 1.4,$$

$$2.5 \leq x2 + y2 \leq 3.5,$$

$$3.5 \leq m2 \leq 4.5,$$

and

$$1.5 \leq n2 \leq 2.49,$$

the silicide having a negative Seebeck coefficient at a temperature of 25°C or higher,

(2) the p-type thermoelectric conversion material is a silicide represented by the compositional formula: $Mn_{m3}M^4_{n3}Si_{p3}$, wherein $M^4$ is at least one element selected from the group consisting of Ti, V, Cr, Fe, Co, Ni, and Cu,

$$0.8 \leq m3 \leq 1.2,$$

$$0 \leq n3 \leq 0.4,$$

and

$$1.5 \leq p3 \leq 2.0,$$

the silicide having a positive Seebeck coefficient at a temperature of 25°C or higher, and
(3) the bonding agent is a conductive paste containing conductive metals consisting of silver and at least one noble metal selected from the group consisting of gold, platinum, and palladium.

Item 2. The thermoelectric conversion element according to Item 1, wherein the conductive paste contains the at least one noble metal selected from the group consisting of gold, platinum, and palladium in a total amount of 0.5 to 95 parts by weight, per 100 parts by weight of silver.

Item 3. The thermoelectric conversion element according to Item 1 or 2, wherein the conductive paste further contains a glass powder component, a resin component, and a solvent component. Item 4. The thermoelectric conversion element according to any one of Items 1 to 3, wherein the conductive substrate is a sheet-shaped conductive metal, a conductive ceramics, or an insulating ceramics on which a conductive metal coating is formed.

Item 5. The thermoelectric conversion element according to Item 4, wherein the conductive substrate is a silver sheet having a thickness of 0.05 to 3 mm.

Item 6. A thermoelectric conversion module comprising a plurality of the thermoelectric conversion elements of any one of Items 1 to 5, wherein the plurality of the thermoelectric conversion elements are connected in series in such a manner that an unconnected end of the p-type thermoelectric conversion material of one of the plurality of the thermoelectric conversion elements and an unconnected end of the n-type thermoelectric conversion material of another one of the plurality of the thermoelectric conversion elements are bonded to a conductive substrate using a bonding agent, and wherein the bonding agent is a conductive paste containing conductive metals consisting of silver and at least one noble metal selected from the group consisting of gold, platinum, and palladium.

Item 7. The thermoelectric conversion module according to Item 6, wherein the conductive paste contains the at least one noble metal selected from the group consisting of gold, platinum, and palladium in a total amount of 0.5 to 95 parts by weight, per 100 parts by weight of silver.

Item 8. The thermoelectric conversion module according to Item 6 or 7, wherein the conductive paste further contains a glass powder component, a resin component, and a solvent component.

Item 9. The thermoelectric conversion module according to any one of Items 6 to 8, wherein the conductive substrate is a sheet-shaped conductive metal, a conductive ceramics, or an insulating ceramics on which a conductive metal coating is formed.

Item 10. The thermoelectric conversion module according to Item 9, wherein the conductive substrate is a silver sheet having a thickness of 0.05 to 3 mm.

Item 11. A thermoelectric conversion module comprising an electrically insulating substrate disposed on both sides or one side of the conductive substrates of the thermoelectric conversion module of any one of Items 6 to 10.

Item 12. The thermoelectric conversion module according to Item 11, wherein the electrically insulating substrate is an oxide ceramics or a nitride ceramics.

Item 13. A thermoelectric generation method comprising a step of positioning one side of the conductive substrates of the thermoelectric conversion module of any one of Items 6 to 11 at a high-temperature section, and the other side of the conductive substrates at a low-temperature section.

First, each material constituting the thermoelectric conversion element of the present invention is described below.

Thermoelectric Conversion Material

(1) n-Type Thermoelectric Conversion Material

The present invention uses a silicide described in the following Item (a) or (b), as an n-type thermoelectric conversion material.

(a) A silicide represented by the compositional formula:

$$Mn_{3-x1}M^1_{x1}Si_{y1}Al_{z1}M^2_{a1},$$

wherein $M^1$ is at least one element selected from the group consisting of Ti, V, Cr, Fe, Co, Ni, and Cu,
$M^2$ is at least one element selected from the group consisting of B, P, Ga, Ge, Sn, and Bi,
$0 \leq x1 \leq 3.0$, in particular $0.1 \leq x1 \leq 2.9$,
$3.5 \leq y1 \leq 4.5$, in particular $3.7 \leq y1 \leq 4.3$,
$2.0 \leq y1 \leq 3.5$, in particular $2.5 \leq y1 \leq 3.5$, and further $2.7 \leq z1 \leq 3.3$,
and $0 \leq a1 \leq 1$, in particular $0.01 \leq a1 \leq 0.99$,

the silicide having a negative Seebeck coefficient at a temperature of 25°C or higher.
(b) A silicide represented by the compositional formula:

$$Mn_{x2}M^3_{y2}Si_{m2}Al_{n2},$$

wherein $M^3$ is at least one element selected from the group consisting of Ti, V, Cr, Fe, Co, Ni, and Cu,
$2.0 \leq x2 \leq 3.5$, in particular $2.2 \leq x2 \leq 3.3$,
$0 \leq y2 \leq 1.4$, in particular $0.1 \leq y2 \leq 1.3$,
$2.5 \leq x2 + y2 \leq 3.5$, in particular $2.7 \leq x2 + y2 \leq 3.3$,
$3.5 \leq m2 \leq 4.5$, in particular $3.7 \leq m2 \leq 4.3$, and
$1.5 \leq n2 \leq 2.49$, in particular $1.6 \leq n2 \leq 2.4$,

the silicide having a negative Seebeck coefficient at a temperature of 25°C or higher.

Both of the silicides described above in Items (a) and (b) have a negative Seebeck coefficient at a temperature in the range of 25 to 700°C; and have a high negative Seebeck coefficient at a temperature of 600°C or less, in particular, in the range of about 300 to 500°C. The silicides exhibit a very low electrical resistivity of 5 mΩ•cm or less at a temperature in the range of 25 to 700°C. Accordingly, the silicides exhibit excellent thermoelectric conversion performance as an n-type thermoelectric conversion material in the above temperature ranges. Furthermore, this metal material has excellent heat resistance, oxidation resistance, etc. For example, the metal material is almost free from thermoelectric conversion performance degradation, even when used for a long period of time at a temperature in the range of about 25 to 700°C.
The method for producing the silicides described above in Items (a) and (b) is not particularly limited. For example, starting materials are first mixed in such a manner that the element ratio thereof becomes the same as that of a target alloy, after which the starting material mixture is melted at a high temperature, and then cooled. Examples of usable starting materials include, in addition to elementary metals, intermetallic compounds comprising a plurality of constituent elements, solid solutions comprising a plurality of constituent elements, and composites thereof (such as alloys). The method for melting the starting materials is also not particularly limited. For example, a method, such as arc melting or induction heating, may be used to perform heating to a temperature exceeding the melting points of the starting material phase and the formation phase. To prevent the oxidation of the starting materials, melting is preferably performed under a non-oxidizing atmosphere, for example, an inert gas atmosphere such as a helium or argon atmosphere, or a non-oxidizing atmosphere such as a reduced-pressure atmosphere. The melt of the metals obtained by the above method becomes, after being cooled, a silicide represented by the above compositional formulas. The obtained silicide may be optionally subjected to heat treatment to obtain a more homogeneous silicide, which improves the performance as a thermoelectric conversion material. The conditions for the heat treatment are not particularly limited, and vary depending on the types, amounts, etc., of the metal elements contained. For example, the heat treatment is preferably conducted at a temperature in the range of about 1,450 to 1,900°C. To prevent the oxidation of the silicide, the heat treatment is preferably conducted under a non-oxidizing atmosphere as in the melting step.

(2) p-Type Thermoelectric Conversion Material

As a p-type thermoelectric conversion material, the present invention uses a silicide represented by the compositional formula:

$$Mn_{m3}M^4_{n3}Si_{p3},$$

wherein $M^4$ is at least one element selected from the group consisting of Ti, V, Cr, Fe, Co, Ni, and Cu,
$0.8 \leq m3 \leq 1.2$, in particular $0.9 \leq m3 \leq 1.1$,
$0 \leq n3 \leq 0.4$, in particular $0.1 \leq n3 \leq 0.3$, and
$1.5 \leq p3 \leq 2.0$, in particular $1.5 \leq p3 \leq 1.9$, and in particular $1.6 \leq p3 \leq 1.8$,

the silicide having a positive Seebeck coefficient at a temperature of 25°C or higher.
This material is generally an alloy having a chimney-ladder structure in which a space within a quadratic prism formed by Mn is occupied with a helical structure of Si.
The silicide represented by the above compositional formula has a positive Seebeck coefficient at a temperature in the range of 25 to 700°C. The silicide material exhibit a low electrical resistivity of 10 mΩ•cm or less at a temperature in the range of 25 to 700°C. Accordingly, this silicide exhibits excellent thermoelectric conversion performance as a p-type thermoelectric conversion material in the above temperature range. Furthermore, the silicide material has excellent heat resistance, oxidation resistance, etc. For example, the material is almost free from thermoelectric conversion performance degradation, even when used for a long period of time at a temperature in the range of about 25 to 700°C.
The method for producing the silicide is not particularly limited. For example, a target silicide may be obtained by melting the starting materials, followed by cooling and optionally heat treatment, as in the silicide to be used as the n-type thermoelectric conversion material.

(3) Sintered Body

For use as thermoelectric conversion materials, both the n-type thermoelectric conversion material and p-type thermoelectric conversion material mentioned above are usually prepared in the form of a sintered body in a shape that is suitable for the intended use. To produce a sintered body, a silicide represented by the above compositional formulas is first pulverized into a fine powder, and then molded into a desirable shape. The degree of pulverization (e.g., particle size, particle size distribution, and particle shape) is not particularly limited; however, making the powder as fine as possible facilitates the subsequent step (i.e., sintering). For example, the use of a pulverization means such as a ball mill enables simultaneous pulverization and mixing of the silicide. The method for sintering the pulverized product is also not particularly limited, and any heating means, such as a commonly used electric heating furnace or gas heating furnace, may be employed. The heating temperature and heating time are also not particularly limited, and these conditions may be suitably determined so that a sintered body having sufficient strength is formed. In particular, the use of electric current sintering enables the production of a dense sintered body in a short time. Electric current sintering is performed by placing a pulverized starting material in an electrically conductive mold, press-molding the material, and then sintering it while applying a pulsed direct current to the mold. The conditions for electric current sintering are also not particularly limited; for example, electric current sintering may be performed by heating at a temperature of about 600 to 850°C for about 5 to 30 minutes optionally under an increased pressure of about 5 to 30 MPa. To prevent the oxidation of the starting materials, the heating is preferably performed under a non-oxidizing atmosphere, for example, an inert gas atmosphere using nitrogen, argon, or the like; a reducing atmosphere; or a reduced-pressure atmosphere. It is also possible to use a hot-press sintering method in which firing is performed in an electric furnace under uniaxial pressure. The conditions for hot-press sintering are also not particularly limited. Heating may be performed at about 700 to 950°C for about 1 to 20 hours under pressure of about 5 to 50 MPa. To prevent the oxidation of the starting materials, the heating is preferably performed under a non-oxidizing atmosphere, for example, an inert gas atmosphere using nitrogen, argon, or the like; a reducing atmosphere; or a reduced-pressure atmosphere.

Conductive Paste

The present invention uses a conductive paste containing conductive metals consisting of silver and at least one noble metal selected from the group consisting of gold, platinum, and palladium. This conductive paste is used as a bonding agent for bonding the n-type thermoelectric conversion material and the p-type thermoelectric conversion material formed of the silicide described above to a conductive substrate.
The use of this conductive paste gives excellent conductivity between the thermoelectric conversion materials and conductive substrate while achieving the formation of joints with sufficient bonding strength. Further, even when electric generation is repeatedly performed, the bonded portions do not easily undergo separation. Even when continuously used in a temperature range of room temperature to about 600°C, the silver is prevented from diffusing into the thermoelectric conversion materials, achieving no degradation of thermoelectric conversion performance, which makes continuous use for a long period of time possible.

Conductive metals, i.e., silver and at least one noble metal selected from the group consisting of gold, platinum, and palladium, contained in the conductive paste may be incorporated as a mixture of each component. It is also possible to incorporate part or all of the conductive metals as an alloy.

The ratio of at least one noble metal selected from the group consisting of gold, platinum, and palladium to silver is such that the total amount of the at least one noble metal selected from the group consisting of gold, platinum, and palladium is preferably about 0.5 to 95 parts by weight, and more preferably about 1 to 20 parts by weight, per 100 parts by weight of silver.

The conductive metals consisting of silver and at least one noble metal selected from the group consisting of gold, platinum, and palladium are usually incorporated as a powder into the conductive paste. The particle size of the metal powder is not particularly limited. The 50% mean particle diameter in the particle size distribution is usually preferably within a range of about 0.05 to 50 μm, and more preferably about 0.2 to 15 μm.

In addition to the silver and the at least one noble metal selected from the group consisting of gold, platinum, and palladium, the conductive paste may further contain a glass powder (frit) component, a resin component, a solvent component, and the like.

Among these, glass powders are a component that mainly shows binding ability when the paste is applied to a joint and heated. Components that may be used as the glass powder are those that undergo melting and show binding ability when heated for bonding, and that maintain sufficient binding ability without undergoing melting when used for thermoelectric generation. Such a glass powder may be suitably selected from glass components that are contained in known conductive pastes. For example, bismuth borosilicate glasses, lead borosilicate glasses, and the like may be used.

Resin components impart appropriate dispersibility, thixotropy, viscosity characteristics, and the like to the paste. Examples of usable resin components include ethylcellulose, hydroxyethyl cellulose, methylcellulose, nitrocellulose, ethylcellulose derivatives, acrylic-based resins, butyral resins, alkyd phenolic resins, epoxy resins, wood rosins, and the like.

As a solvent component, known solvents may be widely used as long as they are capable of uniformly dispersing all of the above components, as long as they have appropriate viscosity so that no dripping, for example, is formed at the time of and after the application, and as long as they are a substance that is liquid at room temperature and that degrades and evaporates when heated. Examples of usable solvents include organic solvents, such as toluene, cyclohexane, isopropyl alcohol, diethylene glycol monobutyl ether acetate (butyl acetate carbitol), terpineol, and the like.

The proportion of each of these components is not particularly limited, and is suitably determined according to target conductivity, thermal expansion coefficient, binding ability, viscosity characteristics, and the like.

The amount of the glass component is, for example, usually about 0.5 to 10 parts by weight, and preferably about 1 to 7 parts by weight, per 100 parts by weight of the conductive metals consisting of silver and at least one noble metal component selected from the group consisting of gold, platinum, and palladium. In the present invention, it is also possible to use the glass component in an amount outside this range.

The amount of the resin component is also not particularly limited, and may be suitably determined within a range such that appropriate workability and adhesiveness are exerted. For example, the resin component is usually used in an amount of about 0.5 to 20 parts by weight, preferably about 1 to 10 parts by weight, and more preferably about 1 to 5 parts by weight, per 100 parts by weight of the conductive metals consisting of silver and at least one noble metal component selected from the group consisting of gold, platinum, and palladium. In the present invention, it is also possible to use the resin component in an amount outside this range.

The solvent component is usually used in an amount of about 3 to 30 parts by weight and preferably 5 to 20 parts by weight, per 100 parts by weight of the conductive metals consisting of silver and at least one noble metal component selected from the group consisting of gold, platinum, and palladium. In the present invention, it is also possible to use the solvent component in an amount outside this range.

The conductive paste may further contain various additives, such as a plasticizer, a lubricant, an antioxidant, and a viscosity modifier, that are contained in known conductive pastes.

As long as the above-described conditions are satisfied, the conductive metals consisting of silver and at least one noble metal selected from the group consisting of gold, platinum, and palladium are contained in the conductive paste in an amount of preferably about 30 wt% or more, more preferably about 70 wt% or more, and still more preferably about 85 to 90 wt% or more, based on the entire conductive paste.

The method for preparing the conductive paste is not particularly limited. For example, the paste may be prepared by mixing conductive metals, and adding other components thereto, followed by kneading. It is also possible to use a commercially available paste containing conductive metals. It is also possible to prepare pastes containing each conductive metal, and kneading these pastes together.

The conductive paste described above may also be used to bond the thermoelectric conversion materials, i.e., the p-type thermoelectric conversion material and n-type thermoelectric conversion material formed of the silicides described above, to a conductive substrate. When the thermoelectric conversion materials are bonded to a conductive substrate using the conductive paste described above, appropriate conductivity, as well as sufficient bonding strength, is imparted to the joints of the thermoelectric conversion materials. Further, even when electric generation at a high temperature is repeated, the silver contained in the conductive paste does not diffuse into the thermoelectric conversion materials, maintaining excellent thermoelectric conversion performance for a long period of time.

## Conductive Substrate

A conductive substrate to which one end of the n-type thermoelectric conversion material and one end of the p-type thermoelectric conversion material are bonded may be a material that can be bonded to the thermoelectric conversion materials and that has sufficient electrical conductivity. Examples of the substrate include a substrate formed of a sheet-shaped conductive metal, a conductive ceramics substrate, a substrate formed of an insulating ceramics on which a conductive metal coating is formed, and the like.

Of these, the conductive metal must be those that do not undergo oxidation or melting at a temperature at which the thermoelectric conversion module is in use. From the viewpoint of stability at a high temperature, it is possible to use, for example, noble metals, such as silver, gold, platinum, and palladium, or a metal consisting of a noble-metal alloy containing about 30 wt% or more of these noble metals, and preferably about 70 wt% or more of these noble metals. Conductive metals disposed at a low-temperature side may be base metals, such as copper, iron, titanium, and aluminum, in addition to the noble metals mentioned above.

The conductive ceramics is preferably a material that does not undergo deterioration in air at a high temperature of about 800°C, and maintains low electrical resistance for a long period of time. For example, an oxide sintered body having low electrical resistivity may be used, such as $LaNiO_3$ and the like, which is an n-type thermoelectric conversion material.

The insulating ceramics is also preferably a material that does not undergo oxidation in air at a high temperature of about 800°C. For example, a substrate formed of an oxide ceramics, such as alumina, may be used. The metal coating formed on the insulating ceramics may be a coating that does not undergo oxidation in air at a high temperature, and has low electrical resistance. For example, a coating of a noble metal, such as silver, gold, or platinum, or a coating of an alloy of these metals may be formed by a vapor deposition method or a method for applying a paste containing these metals.

In the present invention, the conductive substrate, in particular, is preferably a material with low electrical resistivity to increase the output from the thermoelectric conversion module. Further, from the viewpoint of processability, it is more preferable to use a substrate formed of a sheet-shaped conductive metal, since a sheet-shaped conductive metal has flexibility and is not easily broken. Furthermore, from the viewpoint of the cost, electrical resistivity, thermal conductivity, and the like, it is particularly preferable to use a conductive substrate formed of a silver sheet.

The length, width, thickness, and the like of the conductive substrate may be appropriately set according to the size, electrical resistivity, thermal conductivity, and the like of the thermoelectric conversion materials. Further, in order to efficiently transfer heat from a heat source to the high-temperature section of the thermoelectric conversion element, and to efficiently release heat from the low-temperature section, it is desirable to select an electrode material having large thermal conductivity and make the substrate thin.

In the present invention, it is preferable to use a silver sheet having a thickness of about 0.05 to 3 mm.

## Thermoelectric Conversion Element

In the thermoelectric conversion element of the present invention, one end of an n-type thermoelectric conversion material and one end of a p-type thermoelectric conversion material are each bonded to a conductive substrate using a conductive paste.

Fig. 1 schematically shows an example of a thermoelectric conversion element having the above structure.

In the thermoelectric conversion element of the present invention having such a structure, one end of an n-type thermoelectric conversion material and one end of a p-type thermoelectric conversion material are each bonded to a conductive substrate using a conductive paste. As the n-type thermoelectric conversion material, a silicide represented by the compositional formula: $Mn_{3-x1}M^1_{x1}Si_{y1}Al_{z1}M^2_{a1}$, wherein $M^1$, $M^2$, x1, y1, z1, and a1 are as defined above, or a silicide represented by the compositional formula: $Mn_{x2}M^3_{y2}Si_{m2}Al_{n2}$, wherein $M^3$, x2, y2, m2, and n2 are as defined above, is used; as the p-type thermoelectric conversion material, a silicide represented by the compositional formula: $Mn_{m3}M^4_{n3}Si_{p3}$, wherein $M^4$, m3, n3, and p3 are as defined above, is used; and as the bonding agent, a conductive paste containing conductive metals consisting of silver and at least one noble metal selected from the group consisting of gold, platinum, and palladium is used.

The thermoelectric conversion element having such a feature enables effective utilization of excellent thermoelectric generation performance achieved in an intermediate temperature range by the silicides, which are used as the n-type thermoelectric conversion material and the p-type thermoelectric conversion material. Additionally, appropriate conductivity and sufficient bonding strength are imparted to the joints of the thermoelectric conversion materials. Further, even when electric generation is repeated, the silver contained in the conductive paste does not diffuse into the thermoelectric conversion materials, maintaining excellent thermoelectric conversion performance for a long period of time.

The n-type thermoelectric conversion material and p-type thermoelectric conversion material are usually prepared in the form of sintered bodies using a method mentioned above, which may then be optionally processed into a shape suitable for the production of a thermoelectric conversion element. The specific size of the thermoelectric conversion materials is suitably determined according to, for example, the electric generation output, and the size of the high-temperature section and low-temperature section of a thermoelectric conversion module comprising the n-type thermoelectric conversion materials and p-type thermoelectric conversion materials. These thermoelectric conversion materials may be, for example, in the form of a quadratic prism having a depth of 1 to 10 mm, a width of 1 to 10 mm, and a height of about 2 to 20 mm.

Examples of the method for bonding the n-type thermoelectric conversion material and the p-type thermoelectric conversion material to the conductive substrate include a method comprising first applying a conductive paste to each joint of the thermoelectric conversion materials to be bonded to a conductive substrate, and bringing the joints of the conductive substrate into contact. The amount of the conductive paste applied is not particularly limited, and is suitably determined depending on, for example, the specific composition of the paste, so that the thermoelectric conversion materials are bonded with sufficient strength. For example, the conductive paste may be uniformly applied to the joints, so that the thickness of the paste before solidification is about 10 $\mu$m to 500 $\mu$m, and the thickness of the paste layer after solidification becomes about 1 $\mu$m to 200 $\mu$m. For the bonding of the p-type thermoelectric conversion material to the conductive substrate and the bonding of the n-type thermoelectric conversion material to the conductive substrate, conductive pastes of the same composition may be used. It is also possible to use conductive pastes of different compositions for the p-type thermoelectric conversion material and for the n-type thermoelectric conversion material to achieve optimum bonding strength and electrical resistance at the joints.

The size of the conductive substrate is not particularly limited as long as the substrate has a sufficient area to achieve stable bonding to the n-type thermoelectric conversion material and p-type thermoelectric conversion material. In particular, the conductive substrate preferably has a size sufficient to cover the entire joints of the thermoelectric conversion materials.

The joints of the thermoelectric conversion materials are preferably evenly polished to increase the area of contact with the conductive substrate. To strengthen the bonding with the conductive paste and reduce the electrical resistance at the joints, it is preferable to form a metal layer on the joints of the thermoelectric conversion materials. For example, a metal layer may be formed on the joints of the thermoelectric conversion materials by an electroless plating method, such as Ni-B plating.

After the joints of the conductive substrate are brought into contact with the thermoelectric conversion materials via a conductive paste, the solvent contained in the conductive paste is dried, followed by solidification of the conductive paste. This enables bonding of one end of the n-type thermoelectric conversion material and one end of the p-type thermoelectric conversion material to the conductive substrate. For example, the organic components, such as a solvent and an organic binder, contained in the conductive paste may first be decomposed and removed, and heating may then be performed at the softening temperature or higher of the glass component contained in the paste. In this manner, the bonding between the thermoelectric conversion materials and the conductive substrate is strengthened.

The atmosphere at the time of heating is not particularly limited, and may be any atmosphere of air, vacuum, reducing gas, inert gas, or the like. The step of decomposing and removing organic components, such as a solvent and an organic binder, is preferably performed by heat-treatment under an appropriate oxygen partial pressure. For example, heat-treatment may be performed in air at 300 to 500°C for about 1 to 10 hours.

To prevent oxidation of the thermoelectric conversion materials, the step of heat-treatment at the softening temperature or higher of the glass component is preferably performed in an atmosphere of vacuum, reduced pressure, inert gas, or reducing gas. The heating temperature differs depending on the composition of the glass component, and the heat-treatment is preferably performed, for example, at 500 to 900°C for about 1 to 10 hours. In this case, to strengthen the bonding between the thermoelectric conversion materials and the conductive substrate, the heat treatment is preferably performed in a state in which pressure is perpendicularly applied to the joints. The degree of pressure is such that the thermoelectric conversion materials and the conductive substrate do not undergo breakage or deformation. For example, the pressure is about 1 to 20 MPa.

When the thermoelectric conversion materials are bonded to the conductive substrate using the conductive paste, a sintered body containing a glass component, as well as conductive metals, is formed at the joints, which increases the bonding strength.

Thermoelectric Conversion Module

In the thermoelectric generation module of the present invention, a plurality of thermoelectric conversion elements are connected in series in such a manner that the unconnected end of the p-type thermoelectric conversion material of one of the plurality of the thermoelectric conversion elements and the unconnected end of the n-type thermoelectric conversion material of another one of the plurality of the thermoelectric conversion elements are bonded to a conductive substrate using a bonding agent. In the thermoelectric conversion module of the present invention, the conductive paste described above containing conductive metals consisting of silver and at least one noble metal selected from the group consisting of gold, platinum, and palladium is used as a bonding agent.

The conductive substrate used in the production of a thermoelectric conversion module may be a substrate formed of a conductive metal, conductive ceramics, insulating ceramics on which a metal coating is formed, or the like, as in the conductive substrate used in the production of the thermoelectric conversion element. In particular, a substrate formed of a conductive metal is preferable. From the viewpoint of the cost, electrical resistivity, thermal conductivity, and the like, it is preferable to use a substrate formed of a silver sheet.

The method for bonding the thermoelectric conversion materials of the thermoelectric conversion elements to conductive substrates using the bonding agent may be the same bonding method used in the production of the thermoelectric conversion element.

The number of thermoelectric conversion elements used in one module is not limited, and may be appropriately selected depending on the electrical power needed.

In the thermoelectric conversion module of the present invention, when a conductive metal substrate, a conductive ceramic substrate, or the like is used as the conductive substrate, an electrically insulating substrate may further be disposed on the conductive substrates. This enables maintenance of the electrical insulation properties of the conductive substrates, prevention of electrical short between the thermoelectric elements when brought into contact with a conductive portion, such as a heat source, and an improvement of thermal uniformity and mechanical strength.

The material of the electrically insulating substrate is not particularly limited. In the present invention, it is preferable to use an insulating material that does not undergo melting, breakage, or the like at a high temperature of about 1000°C; that is chemically stable; that does not react with thermoelectric conversion materials, a bonding agent, or the like; and that has high thermal conductivity. The use of a substrate with high thermal conductivity allows the temperature of the high-temperature section of the element to become closer to the temperature of a high-temperature heat source, making it possible to increase the voltage generated. Examples of electrically insulating substrates satisfying these conditions include oxide ceramics or nitride ceramics. Specific examples include aluminum oxide, zirconium oxide, titanium oxide, magnesium oxide, silicon oxide, silicon nitride, aluminum nitride, titanium nitride, silicon carbide, and the like.

The shape of the electrically insulating substrate is not particularly limited, and may be determined depending on, for example, the shape and size of the high-temperature section and low-temperature section. From the viewpoint of heat transfer at the high-temperature section and heat release at the low-temperature section, the thickness of the electrically insulating substrate is preferably as thin as possible, and more preferably about 0.1 to 5 mm.

The electrically insulating substrate may be disposed on the conductive substrates at both the high-temperature section and the low-temperature section, or at one of these sections, depending on the type of usage of a thermoelectric conversion module.

The method for disposing the electrically insulating substrate is not particularly limited. For example, an electrically insulating substrate to which conductive substrates are already attached may be used, and thermoelectric conversion materials may then be bonded to the conductive substrates. It is also possible to attach an electrically insulating substrate on conductive substrates after the thermoelectric conversion materials are bonded to the conductive substrates. The means for attaching an electrically insulating substrate are not particularly limited, and means may be used that can form joints that are strong enough to avoid separation or the like during the production of the thermoelectric conversion module and at the time of use thereof. For example, a method for performing heat-treatment to sinter the conductive substrates and an electrically insulating substrate, a method for performing bonding with the use of a paste material, and other methods may be used.

Fig. 2 schematically shows the structure of the (a) side face, (b) front face, and (c) back face of a thermoelectric conversion module using 84 pairs of thermoelectric conversion elements. Fig. 3 schematically shows the structure of the upper and lower faces of this module. In the thermoelectric conversion module shown in Figs. 2 and 3, a plating layer is formed at each joint of the n-type thermoelectric conversion materials and p-type thermoelectric conversion materials to improve bonding properties with the conductive substrates. The electrically insulating substrate is disposed only at one side of the conductive substrates.

The thermoelectric generation module of the present invention can generate voltage when one side of the conductive substrates is positioned so as to be in contact with a high-temperature heat source, and the other side is positioned to be in contact with a low-temperature section. For example, in the module shown in Fig. 2, one side of the conductive substrates to which the electrically insulating substrate is disposed is positioned at the high-temperature section, and the other side is positioned at the low-temperature section. The thermoelectric conversion module of the present invention is not limited to this positioning, as long as one of the sides is positioned at the high-temperature section and the other is positioned at the low-temperature section. For example, in the module shown in Fig. 2, it is also possible to position the high-temperature section side and the low-temperature section side opposite to the above.

The thermoelectric conversion materials used in the thermoelectric conversion elements and thermoelectric conversion module of the present invention are metal materials that show excellent thermoelectric conversion performance in an intermediate temperature range of room temperature to about 700°C, and are effectively used in air, unlike hitherto-known metal materials that were difficult to use in air. Thus, the thermoelectric conversion module of the present invention may be used for thermoelectric generation using, as a heat source, heat of about 400 to 600°C from factories, incinerators, thermal power plants, nuclear power plants, micro turbines, or the like. The application to automobile power sources whose temperature undergoes changes over a wide range is also possible.

Electric generation even from thermal energy of about 400°C or lower is also possible. It is thus possible to use solar heat, boiling water, body temperature, and the like, which are low-temperature heat of about 30 to 200°C, as a heat source. Therefore, when equipped with an appropriate heat source, it is possible to use them as a power source of mobile devices that do not require electric charge, such as cellular phones and notebook PCs.

Advantageous Effects of Invention

The thermoelectric conversion elements and thermoelectric conversion module of the present invention use specific silicides that show excellent performance in an intermediate temperature range of room temperature to about 700°C, as thermoelectric conversion materials. As a bonding agent for bonding these thermoelectric conversion materials to conductive substrates, a paste containing, as conductive metals, silver and at least one noble metal selected from the group consisting of gold, platinum, and palladium is used. In this manner, appropriate conductivity is imparted to the joints of the thermoelectric conversion materials. Further, even when electric generation is repeated in an intermediate temperature range, excellent bonding strength is maintained, and the silver contained in the conductive paste does not diffuse into the thermoelectric conversion materials, maintaining excellent thermoelectric conversion performance for a long period of time.

The use of the thermoelectric conversion module of the present invention enables effective use of a heat source in an intermediate temperature range of room temperature to about 700°C, making efficient thermoelectric generation possible over a long period of time.

Brief Description of Drawings

Fig. 1 schematically shows an example of a thermoelectric conversion element of the present invention.

Fig. 2 schematically shows the structure of the (a) side face, (b) front face, and (c) back face of one example of a thermoelectric conversion module of the present invention.

Fig. 3 schematically shows the structure of the upper and lower faces of one example of a thermoelectric conversion module of the present invention.

Fig. 4 schematically shows the thermoelectric conversion element obtained in Example 1, in which an electrically insulating substrate is provided at one side.

Fig. 5(a) is a graph showing the maximum output of the thermoelectric conversion elements of Example 1 and Comparative Example 1, relative to the temperature of a plate-type electric furnace. Fig. 5(b) is a graph showing the internal resistance of the thermoelectric conversion elements of Example 1 and Comparative Example 1, relative to the temperature of a plate-type electric furnace.

Fig. 6 is a graph showing changes with time of standardized maximum output, in terms of the thermoelectric conversion elements of Example 1 and Comparative Example 1.

Fig. 7(a) is a graph showing the maximum output of the thermoelectric conversion modules of Example 88 and Comparative Example 2, relative to the temperature of a plate-type electric furnace. Fig. 7(b) is a graph showing the internal resistance of the thermoelectric conversion modules of Example 88 and Comparative Example 2, relative to the temperature of a plate-type electric furnace.

Fig. 8 is a graph showing changes with time of the standardized maximum output, in terms of the thermoelectric conversion modules of Example 88 and Comparative Example 2.

Description of Embodiments

The present invention is described below in more detail with reference to Examples.

Example 1

Production of p-Type Thermoelectric Conversion Material

A p-type thermoelectric conversion material represented by the compositional formula: $MnSi_{1.75}$ was produced as follows.

First, small pieces of silicon (Si) and manganese (Mn) were weighed to a ratio of Mn:Si = 1:1.75, and placed in a ceramic crucible, followed by melting in a high-frequency melting furnace. The melt was poured into a room-temperature metal crucible, and rapidly cooled for solidification. The obtained molten solidified product was pulverized using a zirconium crucible and a pestle, and sieved to obtain a powder having a particle size of 38 μm or less. This powder was pressed into a disk shape having a diameter of 10 cm and a thickness of about 5 mm.

This disk was put in a carbon mold, and subjected to hot-press sintering at 920°C for 7 hours under uniaxial pressure of 11 MPa in a vacuum atmosphere. The hot-pressed, sintered body was cut into a prism shape having a cross-section of 3.5 x 3.5 mm and a length of 10 mm. The surfaces of this processed product were electroless-plated with Ni-B. The plating thickness was about 5 μm. The surfaces other than the joints were polished with sandpaper to remove the plating, and a p-type thermoelectric conversion material for use in a thermoelectric conversion module was thus obtained.

Production of n-Type Thermoelectric Conversion Material

Small pieces of manganese (Mn), silicon (Si), and aluminium (Al) were weighed to a ratio of Mn:Si:aluminum (elemental ratio) = 3.0:4.0:2.3. Thereafter, the mixture was melted by an arc-melting method under reduced pressure of about 35 kPa in an argon atmosphere. The melt was then sufficiently mixed, and cooled to room temperature to obtain a molten solidified product formed of the above starting components.

Subsequently, the obtained alloy was pulverized using an agate mortar and a pestle, and sieved to obtain a powder having a particle size of 38 μm or less. The resulting powder was pressed into a disk shape having a diameter of 40 mm and a thickness of about 5 mm. The resulting product was put in a carbon mold, heated to 780°C by applying a pulsed direct current of about 2,700 A (pulse width: 2.5 milliseconds, frequency: 29 Hz), and maintained at that temperature for 15 minutes. After performing electric current sintering, the application of electric current and pressure was stopped, and the resulting product was naturally cooled to obtain a sintered body.

The sintered body was cut into a prism shape having a cross-section of 3.5 x 3.5 mm and a length of 10 mm. The surfaces of this processed product were electroless plated with Ni-B. The thickness of plating was about 5 μm. The surfaces other than the joints were polished with sandpaper to remove the plating, and an n-type thermoelectric conversion material for use in a thermoelectric conversion module was thus obtained.

Preparation of Conductive Paste

A platinum paste (6 parts by weight) (trade name: TR-7905, produced by Tanaka Kikinzoku Kogyo K.K., platinum content: 85 wt%) per 100 parts by weight of a commercially available silver paste (trade name: MH-108A, produced by Tanaka Kikinzoku Kogyo K.K., silver content: 85 wt%) was weighed, and the silver paste and the platinum paste were sufficiently kneaded to prepare a conductive paste. The silver paste used here consists of 85 wt% of silver powder (particle size: about 0.1 to 5 μm), 1 wt% of bismuth borosilicate glass, 5 wt% of ethylcellulose, 4 wt% of terpineol, and 5 wt% of butylcarbitol acetate, while the platinum paste used here consists of 85 wt% of platinum powder (particle size: about 0.1 to 5 μm), 1 wt% of bismuth borosilicate glass, 5 wt% of ethylcellulose, 4 wt% of terpineol, and 5 wt% of butylcarbitol acetate.

Production of Thermoelectric Conversion Element

A silver sheet having a width of 3.5 mm, a length of 7 mm, and a thickness of 0.5 mm was prepared as a conductive substrate, and the conductive paste containing the silver and platinum powders was applied to the Ni-B plated surfaces (3.5 mm x 3.5 mm) of the p-type thermoelectric conversion material and n-type thermoelectric conversion material, on the surfaces of which the silver sheet was placed so as to connect the p-type thermoelectric conversion material to the n-type thermoelectric conversion material. Additionally, an electrically insulating aluminum oxide substrate having a width of 5 mm, a length of 8 mm, and a thickness of 0.5 mm was further placed on the silver sheet to cover the entire silver sheet. The paste was applied in such an amount that the thickness before solidification was about 100 μm.

The thermoelectric conversion element above was turned upside down, and the conductive paste was applied in a manner similar to the above to the opposing cross sections of the thermoelectric conversion materials. Two silver sheets were individually placed on each of the n-type thermoelectric material and p-type thermoelectric material; the sheets were used as lead wires for collecting electric current.

After drying at about 100°C for about 30 minutes, the resulting product was heated at 350°C for 5 hours in air to decompose the organic components. The resulting thermoelectric conversion element was then subjected to heat treatment at 600°C for 7 hours in vacuum in a state in which a uniaxial pressure of 6.5 MPa was perpendicularly applied to the joints. In this manner, the conductive paste was solidified.

The paste after solidification had a thickness of about 20 μm. The aluminum oxide substrate placed on the silver sheet was adhered by heating to the silver sheet during the heat treatment. In this manner, a thermoelectric conversion element having an electrically insulating substrate at one side was obtained. Fig. 4 schematically shows the obtained thermoelectric conversion element.

Comparative Example 1

A thermoelectric conversion element was produced as in Example 1, except that a commercially available silver paste (trade name: MH-108A, produced by Tanaka Kikinzoku Kogyo K.K., silver content: 85 wt%) was used as the conductive paste.

Test Example 1

The aluminum oxide substrate side of the thermoelectric conversion elements obtained in Example 1 and Comparative Example 1 was heated at 100 to 600°C in air using a plate-type electric furnace while the opposing ends were cooled with a copper jacket in which water at 20°C was circulated, thereby producing a temperature difference.

The lead wires (silver sheets) provided at the low-temperature side of the p-type thermoelectric conversion material and the n-type thermoelectric conversion material were connected to an electronic load device, and electric current-voltage characteristics were measured while changing external load resistance. In this manner, the internal resistance and output of the module were obtained. In this measurement, the electric current-voltage characteristics are obtained as a straight line, and the absolute values of the slope (negative value) of this straight line serve as the internal resistances of the thermoelectric conversion element. The output is multiplication of electric current and voltage, and forms a quadratic function. The measurement values were regressed to the quadratic function, and the maximum local value of the quadratic curve obtained from the function was considered as the maximum output. When the external load resistance is equal to the internal resistance, a thermoelectric conversion element shows the maximum output. Based on the regression curve as well, the maximum output was obtained at the point in which the external load resistance was equal to the internal resistance.

Fig. 5(a) is a graph showing the maximum output of the thermoelectric conversion elements of Example 1 and Comparative Example 1, relative to the temperature of a plate-type electric furnace. Fig. 5(b) is a graph showing the internal resistance of the thermoelectric conversion elements of Example 1 and Comparative Example 1, relative to the temperature of a plate-type electric furnace. The thermoelectric conversion element obtained in Example 1 showed lower internal resistance values, resulting in higher maximum output.

These results clarify the following: in Example 1, the thermoelectric conversion materials were bonded to the silver sheets using the paste containing silver and platinum; in this manner, the silver was prevented from diffusing into the thermoelectric conversion materials at the time of the production of the element and at the time of heating in the test, achieving excellent thermoelectric generation performance. In contrast, in Comparative Example 1, in which a silver paste was used as the bonding agent, the silver diffused into the thermoelectric conversion element at the time of heating, which is presumably why the thermoelectric generation performance was degraded.

Fig. 6 is a graph showing changes with time of the maximum output when the test was performed for a long period of time with the temperature of a plate-type electric furnace adjusted to 600°C. The vertical axis shows maximum output values standardized by the maximum output measured immediately after the plate-type electric furnace temperature reached 600°C. The maximum output of Comparative Example 1 greatly reduced with time; however, almost no change was observed in Example 1. These results confirm that bonding of the thermoelectric conversion materials to the silver sheets using the paste containing silver and platinum improves the durability in high-temperature air.

Examples 2 to 87

Thermoelectric conversion elements were produced as in Example 1 using the materials shown in Table 1 as the p-type thermoelectric conversion material, n-type thermoelectric conversion material, conductive substrate, and electrically insulating substrate. The method for disposing the insulating substrate at the high-temperature side and the insulating substrate at the low-temperature side is the same as that for disposing the aluminum oxide substrate in Example 1.

The "Noble metal mixture" column in Table 1 shows the types of noble metals incorporated in the conductive paste, in addition to silver; the "Mixed amount with respect to silver" column shows the amount of the noble metals in percent by weight, on the assumption that the silver amount was 100 wt%. The conductive substrates used at the high-temperature and low-temperature sides are respectively shown as a high-temperature-side electrode material and a low-temperature-side electrode material.

A test was performed for a long period of time as in Test Example 1, with the plate-type electric furnace temperature adjusted to 600°C, and the maximum output after 15 hours was measured. Each table shows the ratio of the maximum output after 15 hours to the initial value. The maximum output and internal resistance of the thermoelectric conversion elements obtained in Examples 2 to 87 vary depending on, for example, the composition of the thermoelectric conversion materials, the materials of the conductive substrate, and the composition of the noble metals in the conductive paste. All of the thermoelectric conversion elements showed a smaller change in the maximum output, compared with the thermoelectric conversion element obtained in Comparative Example 1, and the change was almost the same as that of Example 1. These results confirm that bonding of the thermoelectric conversion materials to the silver sheets using the paste containing silver and platinum improves the durability in high-temperature air.

Table 1-1

| Ex. | Composition of n-type thermoelectric conversion material | Composition of p-type thermoelectric conversion material | Noble metal mixture | Mixed amount with respect to silver (wt%) | High-temperature-side electrode material | Low-temperature-side electrode material | High-temperature-side insulating substrate | Low-temperature-side insulating substrate | Maximum output (15 hours)/ Maximum output (0 hours) |
|---|---|---|---|---|---|---|---|---|---|
| 1 | $Mn_3Si_4Al_{2.3}$ | $MnSi_{1.75}$ | Platinum | 6 | Silver | Silver | Aluminum oxide | None | 1.01 |
| 2 | $Mn_3Si_4Al_{2.3}$ | $MnSi_{1.75}$ | Gold | 6 | Silver | Silver | Aluminum oxide | None | 1.00 |
| 3 | $Mn_3Si_4Al_{2.3}$ | $MnSi_{1.75}$ | Palladium | 6 | Silver | Silver | Aluminum oxide | None | 0.998 |
| 4 | $Mn_3Si_4Al_{2.3}$ | $MnSi_{1.75}$ | Platinum | 0.5 | Silver | Silver | Aluminum oxide | None | 0.980 |
| 5 | $Mn_3Si_4Al_{2.3}$ | $MnSi_{1.75}$ | Gold | 0.5 | Silver | Silver | Aluminum oxide | None | 0.991 |
| 6 | $Mn_3Si_4Al_{2.3}$ | $MnSi_{1.75}$ | Palladium | 0.5 | Silver | Silver | Aluminum oxide | None | 0.978 |
| 7 | $Mn_3Si_4Al_{2.3}$ | $MnSi_{1.75}$ | Platinum | 20 | Silver | Silver | Aluminum oxide | None | 0.993 |
| 8 | $Mn_3Si_4Al_{2.3}$ | $MnSi_{1.75}$ | Gold | 20 | Silver | Silver | Aluminum oxide | None | 1.01 |
| 9 | $Mn_3Si_4Al_{2.3}$ | $MnSi_{1.75}$ | Palladium | 50 | Silver | Silver | Aluminum oxide | None | 0.994 |
| 10 | $Mn_3Si_4Al_{2.3}$ | $MnSi_{1.75}$ | Platinum | 95 | Silver | Silver | Aluminum oxide | None | 0.982 |
| 11 | $Mn_3Si_4Al_{2.3}$ | $MnSi_{1.75}$ | Gold | 95 | Silver | Silver | Aluminum oxide | None | 0.987 |
| 12 | $Mn_3Si_4Al_{2.3}$ | $MnSi_{1.75}$ | Palladium | 95 | Silver | Silver | Aluminum oxide | None | 0.977 |
| 13 | $Mn_{2.7}Cr_{0.3}Si_4Al_{23}$ | $MnSi_{1.76}$ | Platinum | 6 | Silver | Silver | Aluminum oxide | None | 0.987 |

(continued)

| Ex. | Composition of n-type thermoelectric conversion material | Composition of p-type thermoelectric conversion material | Noble metal mixture | Mixed amount with respect to silver (wt%) | High-temperature-side electrode material | Low-temperature-side electrode material | High-temperature-side insulating substrate | Low-temperature-side insulating substrate | Maximum output (15 hours)/ Maximum output (0 hours) |
|---|---|---|---|---|---|---|---|---|---|
| 14 | $Mn_{2.8}Co_{0.2}Si_4Al_3$ | $MnSi_{1.75}$ | Platinum | 6 | Gold | Gold | Zirconium oxide | Zirconium oxide | 0.986 |
| 15 | $Mn_{2.8}Fe_{0.2}Si_4Al_3$ | $MnSi_{1.75}$ | Platinum | 20 | Platinum | Platinum | Zirconium oxide | Zirconium oxide | 0.996 |
| 16 | $Mn_{2.8}Ni_{0.2}Si_4Al_3$ | $MnSi_{1.75}$ | Platinum | 0.5 | Silver | Silver | Aluminum oxide | Aluminum oxide | 1.00 |
| 17 | $Mn_3Si_{4.5}Al_3$ | $MnSi_{2.0}$ | Platinum | 50 | Platinum | Platinum | Aluminum oxide | Aluminum oxide | 0.989 |
| 18 | $Mn_3Si_{4.2}Al_{2.8}$ | $MnSi_{1.75}$ | Gold | 6 | Silver | Silver | Aluminum oxide | Aluminum oxide | 0.981 |
| 19 | $Mn_3Si_{3.8}Al_{3.2}$ | $MnSi_{1.5}$ | Palladium | 6 | Palladium | Palladium | Titanium oxide | Titanium oxide | 0.990 |
| 20 | $Mn_3Si_{3.5}Al_3$ | $MnSi_{1.6}$ | Platinum | 10 | Silver | Silver | Aluminum oxide | Aluminum oxide | 0.990 |
| 21 | $Mn_3Si_{3.9}Al_3$ | $MnSi_{1.8}$ | Platinum | 6 | Silver | Silver | Aluminum oxide | Aluminum oxide | 1.00 |
| 22 | $Mn_3Si_{3.8}Al_3P_{0.2}$ | $MnSi_{1.75}$ | Gold | 6 | Gold | Gold | Magnesium oxide | Magnesium oxide | 0.999 |
| 23 | $Mn_3Si_4Al_2P$ | $MnSi_{1.75}$ | Gold | 10 | Gold | Gold | Silicon oxide | Silicon oxide | 1.01 |
| 24 | $Mn_3Si_{3.8}Al_3B_{0.2}$ | $MnSi_{1.75}$ | Gold | 20 | Gold | Gold | Silicon nitride | Silicon nitride | 0.992 |
| 25 | $Mn_3Si_4Al_2B$ | $MnSi_{1.75}$ | Gold | 6 | Gold | Gold | Titanium nitride | Titanium nitride | 0.979 |
| 26 | $Mn_3Si_{3.8}Al_3Ga_{0.2}$ | $MnSi_{1.75}$ | Palladium | 10 | Palladium | Palladium | Magnesium oxide | Magnesium oxide | 0.991 |
| 27 | $Mn_3Si_4Al_2Ga$ | $MnSi_{1.75}$ | Palladium | 20 | Palladium | Palladium | Silicon oxide | Silicon oxide | 0.982 |

(continued)

| Ex. | Composition of n-type thermoelectric conversion material | Composition of p-type thermoelectric conversion material | Noble metal mixture | Mixed amount with respect to silver (wt%) | High-temperature-side electrode material | Low-temperature-side electrode material | High-temperature-side insulating substrate | Low-temperature-side insulating substrate | Maximum output (15 hours)/ Maximum output (0 hours) |
|---|---|---|---|---|---|---|---|---|---|
| 28 | $Mn_3Si_{3.8}Al_3Ge_{0.2}$ | $MnSi_{1.75}$ | Palladium | 10 | Palladium | Palladium | Silicon nitride | Silicon nitride | 0.973 |
| 29 | $Mn_3Si_4Al_2Ge$ | $MnSi_{1.75}$ | Palladium | 20 | Palladium | Palladium | Silicon carbide | Silicon carbide | 0.973 |
| 30 | $Mn_3Si_{3.8}Al_3Sn_{0.2}$ | $MnSi_{1.75}$ | Platinum | 6 | Silver | Silver | Aluminum oxide | None | 0.984 |

Table 1-2

| | | | | | | | | | |
|---|---|---|---|---|---|---|---|---|---|
| 31 | $Mn_3Si_4Al_2Sn$ | $MnSi_{1.75}$ | Platinum | 6 | Silver | Silver | Aluminum oxide | None | 0.994 |
| 32 | $Mn_3Si_{3.8}Al_3Bi_{0.2}$ | $MnSi_{1.75}$ | Platinum | 6 | Silver | Silver | None | None | 0.985 |
| 33 | $Mn_3Si_4Al_2Bi$ | $MnSi_{1.75}$ | Platinum | 6 | Silver | Silver | None | None | 0.975 |
| 34 | $Mn_3Si_4Al_3Bi_{0.02}$ | $MnSi_{1.75}$ | Platinum | 6 | Silver | Silver | None | None | 0.986 |
| 35 | $Mn_{2.9}Ti_{0.1}Si_4Al_3$ | $MnSi_{1.75}$ | Platinum | 6 | Silver | Silver | None | None | 0.996 |
| 36 | $Ti_3Si_4Al_3$ | $MnSi_{1.75}$ | Platinum | 6 | Gold | Titanium | Titanium nitride | Aluminum oxide | 0.978 |
| 37 | $Mn_{2.9}V_{0.1}Si_4Al_3$ | $MnSi_{1.75}$ | Platinum | 6 | Silver | Silver | Aluminum oxide | Aluminum oxide | 1.00 |
| 38 | $V_3Si_4Al_3$ | $MnSi_{1.75}$ | Gold | 10 | Gold | Copper | Silicon nitride | Aluminum oxide | 0.971 |
| 39 | $Mn_{2.9}Cr_{0.1}Si_4Al_3$ | $MnSi_{1.75}$ | Platinum | 6 | Silver | Silver | Aluminum oxide | Aluminum oxide | 0.982 |
| 40 | $Cr_3Si_4Al_3$ | $MnSi_{1.75}$ | Gold | 6 | Gold | Copper | Silicon nitride | Aluminum oxide | 0.978 |
| 41 | $Mn_{2.9}Fe_{0.1}Si_4Al_3$ | $MnSi_{1.75}$ | Platinum | 15 | Silver | Silver | Aluminum oxide | Aluminum oxide | 0.990 |
| 42 | $Fe_3Si_4Al_3$ | $MnSi_{1.75}$ | Gold | 10 | Gold | Iron | Silicon nitride | Aluminum oxide | 0.970 |
| 43 | $Mn_{2.9}Co_{0.1}Si_4Al_3$ | $MnSi_{1.75}$ | Platinum | 6 | Silver | Silver | Aluminum oxide | Aluminum oxide | 0.096 |
| 44 | $Co_3Si_4Al_3$ | $MnSi_{1.75}$ | Gold | 10 | Gold | Copper | Silicon nitride | Aluminum oxide | 0.979 |
| 45 | $Mn_{2.9}Ni_{0.1}Si_4Al_3$ | $MnSi_{1.75}$ | Platinum | 6 | Silver | Silver | Aluminum oxide | Aluminum oxide | 0.992 |
| 46 | $Ni_3Si_4Al_3$ | $MnSi_{1.75}$ | Gold | 10 | Gold | Copper | Silicon nitride | Aluminum oxide | 0.983 |
| 47 | $Mn_{2.9}Cu_{0.1}Si_4Al_3$ | $MnSi_{1.75}$ | Platinum | 6 | Silver | Silver | Aluminum oxide | None | 0.979 |
| 48 | $Cu_3Si_4Al_3$ | $MnSi_{1.75}$ | Gold | 10 | Gold | Copper | Aluminum nitride | None | 0.982 |
| 49 | $Mn_{2.9}Cr_{0.1}Si_4Al_2$ | $MnAl_{1.75}$ | Platinum | 6 | Silver | Silver | Aluminum oxide | None | 0.973 |
| 50 | $Mn_{2.7}Cr_{0.3}Si_4Al_2$ | $MnSi_{1.75}$ | Platinum | 6 | Silver | Silver | Aluminum oxide | None | 0.992 |
| 51 | $Mn_{2.7}Cr_{0.3}Si_4Al_2$ | $Mn_{0.9}Cr_{0.1}Si_{1.75}$ | Platinum | 6 | Silver | Silver | Aluminum oxide | None | 1.01 |
| 52 | $Mn_{2.6}Cr_{0.4}Si_4Al_2$ | $MnSi_{1.75}$ | Platinum | 6 | Silver | Silver | Aluminum oxide | None | 0.992 |
| 53 | $Mn_{2.6}Cr_{0.4}Si_{3.5}Al_2$ | $MnSi_{1.75}$ | Platinum | 6 | Silver | Silver | Aluminum oxide | None | 0.979 |
| 54 | $Mn_{2.6}Cr_{0.4}Si_{4.5}Al_{1.5}$ | $MnSi_{1.75}$ | Platinum | 6 | Silver | Silver | Aluminum oxide | None | 0.991 |
| 55 | $Mn_{2.6}Cr_{0.4}Si_{3.5}Al_{2.4}$ | $MnSi_{1.75}$ | Platinum | 6 | Silver | Silver | Aluminum oxide | None | 0.982 |
| 56 | $Mn_{2.3}Cr_{0.7}Si_4Al_2$ | $MnSi_{1.75}$ | Platinum | 6 | Silver | Silver | Aluminum oxide | None | 0.973 |

(continued)

| | | | | | | | | | |
|---|---|---|---|---|---|---|---|---|---|
| 57 | $Mn_{2.7}Ti_{0.3}Si_4Al_2$ | $Mn_{0.9}Ti_{0.1}Si_{1.75}$ | Gold | 10 | Silver | Silver | Titanium nitride | None | 0.992 |
| 58 | $Mn_{2.7}V_{0.3}Si_4Al_2$ | $Mn_{0.9}V_{0.1}Si_{1.75}$ | Gold | 10 | Silver | Silver | Titanium nitride | None | 0.979 |
| 59 | $Mn_{2.7}Fe_{0.3}Si_4Al_2$ | $Mn_{0.9}Fe_{0.1}Si_{1.75}$ | Gold | 10 | Silver | Silver | Aluminum nitride | None | 0.991 |
| 60 | $Mn_{2.7}Co_{0.3}Si_4Al_2$ | $Mn_{0.9}Co_{0.1}Si_{1.75}$ | Gold | 10 | Silver | Silver | Aluminum nitride | None | 0.992 |

Table 1-3

| | | | | | | | | | |
|---|---|---|---|---|---|---|---|---|---|
| 61 | $Mn_{2.7}Ni_{0.3}Si_4Al_2$ | $Mn_{0.9}Ni_{0.1}Si_{1.75}$ | Gold | 10 | Silver | $LaNiO_3$ | Aluminum nitride | None | 0.984 |
| 62 | $Mn_{2.7}Cu_{0.3}Si_4Al_2$ | $Mn_{0.9}Cu_{0.1}Si_{1.75}$ | Gold | 10 | Silver | Silver | Aluminum nitride | None | 0.979 |
| 63 | $Mn_{2.3}Ti_{0.7}Si_4Al_2$ | $MnSi_{1.75}$ | Platinum | 6 | Silver | Silver | Aluminum oxide | None | 1.00 |
| 64 | $Mn_{2.3}V_{0.7}Si_4Al_2$ | $MnSi_{1.75}$ | Platinum | 6 | Silver | Silver | Aluminum oxide | None | 0.999 |
| 65 | $Mn_{2.3}Fe_{0.7}Si_4Al_2$ | $MnSi_{1.75}$ | Platinum | 6 | Silver | Silver | Aluminum oxide | None | 1.01 |
| 66 | $Mn_{2.3}Co_{0.7}Si_4Al_2$ | $MnSi_{1.75}$ | Platinum | 6 | Silver | Silver | Aluminum oxide | None | 0.992 |
| 67 | $Mn_{2.3}Ni_{0.7}Si_4Al_2$ | $MnSi_{1.75}$ | Platinum | 6 | Silver | Silver | Aluminum oxide | None | 0.979 |
| 68 | $Mn_{2.3}Cu_{0.7}Si_4Al_2$ | $MnSi_{1.75}$ | Platinum | 6 | Silver | Silver | Aluminum oxide | None | 0.991 |
| 69 | $Mn_{2.0}Cr_{0.3}Ti_{0.2}Si_4Al_2$ | $Mn_{0.9}Cr_{0.1}Si_{1.75}$ | Platinum | 6 | Silver | Silver | Aluminum oxide | None | 0.982 |
| 70 | $Mn_{2.0}Cr_{0.3}V_{0.2}Si_4Al_2$ | $Mn_{0.9}Cr_{0.1}Si_{1.75}$ | Platinum | 6 | Silver | Silver | Aluminum oxide | None | 0.973 |
| 71 | $Mn_{2.0}Cr_{0.3}Fe_{0.2}Si_4Al_2$ | $Mn_{0.9}Cr_{0.1}Si_{1.75}$ | Platinum | 6 | Silver | Silver | Aluminum oxide | None | 1.00 |
| 72 | $Mn_{2.0}Cr_{0.3}Co_{0.2}Si_4Al_2$ | $Mn_{0.9}Cr_{0.1}Si_{1.75}$ | Platinum | 6 | Silver | Silver | Aluminum oxide | None | 0.999 |
| 73 | $Mn_{2.0}Cr_{0.3}Ni_{0.2}Si_4Al_2$ | $Mn_{0.9}Cr_{0.1}Si_{1.75}$ | Platinum | 6 | Silver | Silver | Aluminum oxide | None | 1.01 |
| 74 | $Mn_{2.0}Cr_{0.3}Cu_{0.2}Si_4Al_2$ | $Mn_{0.9}Cr_{0.1}Si_{1.75}$ | Platinum | 6 | Silver | Silver | Aluminum oxide | None | 0.992 |
| 75 | $Mn_{2.5}Cr_{0.3}Ti_{0.5}Si_4Al_2$ | $Mn_{0.9}Cr_{0.1}Si_{1.75}$ | Platinum | 6 | Silver | Silver | Aluminum oxide | None | 0.979 |
| 76 | $Mn_{2.0}Cr_{0.7}Ti_{0.7}Si_4Al_2$ | $Mn_{0.9}Cr_{0.1}Si_{1.75}$ | Platinum | 6 | Silver | Silver | Aluminum oxide | None | 0.991 |
| 77 | $Mn_{2.0}Cr_{0.7}V_{0.7}Si_4Al_2$ | $Mn_{0.9}Cr_{0.1}Si_{1.75}$ | Platinum | 6 | Silver | Silver | Aluminum oxide | None | 0.982 |
| 78 | $Mn_{2.0}Cr_{0.7}Cr_{0.7}Si_4Al_2$ | $Mn_{0.9}Cr_{0.1}Si_{1.75}$ | Platinum | 6 | Silver | Silver | Aluminum oxide | None | 0.973 |
| 79 | $Mn_{2.0}Cr_{0.7}Fe_{0.7}Si_4Al_2$ | $Mn_{0.9}Cr_{0.1}Si_{1.75}$ | Platinum | 6 | Silver | Silver | Aluminum oxide | None | 0.973 |
| 80 | $Mn_{2.0}Cr_{0.7}Co_{0.7}Si_4Al_2$ | $Mn_{0.9}Cr_{0.1}Si_{1.75}$ | Platinum | 6 | Silver | Silver | Aluminum oxide | None | 0.984 |
| 81 | $Mn_{2.0}Cr_{0.7}Ni_{0.7}Si_4Al_2$ | $Mn_{0.9}Cr_{0.1}Si_{1.75}$ | Platinum | 6 | Silver | Silver | Aluminum oxide | None | 0.994 |
| 82 | $Mn_{2.0}Cr_{0.7}Cu_{0.7}Si_4Al_2$ | $Mn_{0.9}Cr_{0.1}Si_{1.75}$ | Platinum | 6 | Silver | Silver | Aluminum oxide | None | 0.985 |
| 83 | $Mn_{3.5}Si_4Al_{2.49}$ | $MnSi_{1.75}$ | Platinum | 6 | Silver | Silver | Aluminum oxide | None | 0.975 |
| 84 | $Mn_3Si_4Al_{2.3}$ | $MnSi_{1.75}$ | Platinum·Gold | 3 (Platinum) ·3 (Gold) | Silver | Silver | Aluminum oxide | None | 0.986 |
| 85 | $Mn_3Si_4Al_{2.3}$ | $MnSi_{1.75}$ | Platinum· Palladium | 3 (Platinum)· 6 (Palladium) | Silver | Silver | Aluminum oxide | None | 0.996 |
| 86 | $Mn_3Si_4Al_{2.3}$ | $MnSi_{1.75}$ | Platinum (n-type) ·Gold (p-type) | 6 (Platinum) ·6 (Gold) | Silver | Silver | Aluminum oxide | None | 0.978 |

(continued)

| | | | | | | | | | |
|---|---|---|---|---|---|---|---|---|---|
| 87 | $Mn_3Si_4Al_{2.3}$ | $MnSi_{1.75}$ | Platinum (n-type)· Palladium (p-type) | 6 (Platinum)· 6 (Palladium) | Silver | Silver | Aluminum oxide | None | 0.985 |

Example 88

Production of Thermoelectric Conversion Module

Seven silver sheets having a width of 7 mm, a length of 7 mm, and a thickness of 0.5 mm were placed on an aluminum oxide substrate with a size of 3 x 3 cm and a thickness of 0.8 mm at intervals appropriate to allow the thermoelectric conversion materials to be connected.

As p-type thermoelectric conversion materials and n-type thermoelectric conversion materials, materials in a prism shape having a cross-section of 3.5 x 7 mm and a length of 10 mm produced as in Example 1 were used.

The same conductive paste as used in Example 1 was applied to both of the 3.5 mm x 7 mm surfaces of each of the thermoelectric conversion materials, and one pair of the p-type thermoelectric conversion material and n-type thermoelectric conversion material was placed on each silver sheet disposed on the aluminum oxide substrate. Altogether, 14 each of the p-type thermoelectric conversion materials and n-type thermoelectric conversion materials were alternately disposed. The paste was applied in such an amount that the thickness before solidification was about 100 $\mu$m.

Silver sheets having a width of 7 mm, a length of 7 mm, and a thickness of 0.5 mm were individually placed on the other surfaces of the thermoelectric conversion materials to which the conductive paste was applied, and 14 pairs (28 in total) of the thermoelectric conversion materials were connected in series with the additional use of the silver sheets on the aluminum oxide substrate. Silver sheets having a width of 7 mm, a length of 50 mm, and a thickness of 0.5 mm were individually placed on the surfaces of the p-type thermoelectric conversion material and n-type thermoelectric conversion material at both ends of the series connection, and used as lead wires. In this manner, a thermoelectric conversion module precursor having 14 pairs of thermoelectric conversion elements was produced.

This precursor was dried at about 100°C for about 30 minutes, followed by heating at 350°C for 5 hours in air to thermally decompose the organic components. Next, the conductive paste was solidified by heat treatment at 600°C for 7 hours in vacuum in a state in which a uniaxial pressure of 6.5 MPa was perpendicularly applied to the joints. The paste layer after solidification had a thickness of about 20 $\mu$m. The aluminum oxide substrate was adhered by heating to the silver sheets during the heat treatment. In this manner, a thermoelectric conversion module in which 14 pairs of thermoelectric conversion elements were connected in series, and an electrically insulating substrate was disposed at one side was obtained.

Example 89

As p-type thermoelectric conversion materials and n-type thermoelectric conversion materials, materials in a prism shape having a cross-section of 3.5 x 7 mm and a length of 10 mm produced as in Example 1 were used. However, a Ni-B electroless plating layer was not formed on the surfaces of both the p-type thermoelectric conversion materials and the n-type thermoelectric conversion materials.

A thermoelectric conversion module in which 14 pairs of thermoelectric conversion elements were connected in series, and in which an electrically insulating substrate was disposed at one side was obtained as in Example 88, except that these p-type thermoelectric conversion materials and n-type thermoelectric conversion materials were used.

Comparative Example 2

A thermoelectric conversion module in which 14 pairs of thermoelectric conversion elements were connected in series, and in which an electrically insulating substrate was disposed at one side was obtained as in Example 88, except that a commercially available silver paste (trade name: MH-108A, produced by Tanaka Kikinzoku Kogyo K.K., silver content: 85 wt%) was used as the conductive paste.

Test Example 2

The aluminum oxide substrate portion of the thermoelectric conversion modules obtained as above in Example 88, Example 89, and Comparative Example 2 was heated at 100 to 600°C in air using a plate-type electric furnace while the opposing ends were cooled with a copper jacket in which 20°C water was circulated, thereby producing a temperature difference.

The lead wires provided at the low-temperature side of the p-type thermoelectric conversion material and the low-temperature side of the n-type thermoelectric conversion material were connected to an electronic load device, and electric current-voltage characteristics of the module were measured while changing external load resistance. In this manner, the internal resistance and output of the module were obtained. In this measurement, the electric current-voltage characteristics are obtained as a straight line, and the absolute values of the slope (negative value) of this straight line serve as the internal resistances of the thermoelectric conversion module. The output is multiplication of electric current and voltage, and forms a quadratic function. The measurement values were regressed to the quadratic function, and the maximum local value of the quadratic curve obtained from the function was considered as the maximum output. When the external load resistance is equal to the internal resistance, a thermoelectric conversion module shows the maximum output. Based on the regression curve as well, the maximum output was obtained at the point in which the external load resistance was equal to the internal resistance.

Fig. 7(a) is a graph showing the maximum output of the thermoelectric conversion modules of Example 88, Example 89, and Comparative Example 2, relative to the temperature of a plate-type electric furnace. Fig. 7(b) is a graph showing the internal resistance of the thermoelectric conversion modules of Example 88, Example 89, and Comparative Example 2, relative to the temperature of a plate-type electric furnace.

The thermoelectric conversion modules obtained in Example 88 and Example 89 showed lower internal resistance values, resulting in higher maximum output. In particular, the thermoelectric conversion module of Example 88, in which a Ni plating layer was formed, had a low internal resistance, and the thermoelectric conversion module of Example 89 also had a sufficiently low internal resistance value. These results clarify the following: in Example 88 and Example 89, the thermoelectric conversion materials were bonded to the silver sheets using the paste containing silver and platinum; in this manner, the silver was prevented from diffusing into the thermoelectric conversion materials at the time of the production of the modules and at the time of heating in the test, achieving excellent thermoelectric generation performance. In contrast, in Comparative Example 2, in which a silver paste was used as the bonding agent, the silver diffused into the thermoelectric conversion element at the time of heating, which is presumably the reason why the thermoelectric generation performance was degraded.

Fig. 8 shows changes with time of the maximum output when the test was performed for a long period of time with the plate-type electric furnace temperature adjusted to 600°C. The vertical axis shows maximum output values standardized by the maximum output measured immediately after the plate-type electric furnace temperature reached 600°C. The maximum output of Comparative Example 2 greatly reduced with time; however, almost no change was observed in Example 88. Example 89 also showed a smaller reduction in the maximum output, compared to Comparative Example 2. These results confirm that bonding of the thermoelectric conversion materials to the silver sheets using the paste containing silver and platinum improves the durability in high-temperature air.

Examples 90 to 98

Thermoelectric conversion modules were produced as in Example 88 using the materials shown in Table 2 as the p-type thermoelectric conversion material, n-type thermoelectric conversion material, conductive substrate, and electrically insulating substrate. The method for disposing the insulating substrate at the high-temperature side and the insulating substrate at the low-temperature side is the same as that for disposing the aluminum oxide substrate in Example 88.

The "Noble metal mixture" column in Table 2 shows the types of noble metals incorporated in the conductive paste, in addition to silver; the "Mixed amount with respect to silver" column shows the amount of the noble metals in percent by weight, on the assumption that the silver amount was 100 wt%. The conductive substrates used at the high-temperature and low-temperature sides are respectively shown as a high-temperature-side electrode material and a low-temperature-side electrode material.

A test was performed for a long period of time as in Test Example 2, with the plate-type electric furnace temperature adjusted to 600°C, and the maximum output after 15 hours was measured. Table 2 shows the ratio of the maximum output after 15 hours to the initial value. The maximum output and internal resistance of the thermoelectric conversion modules obtained in Examples 90 to 98 vary depending on, for example, the composition of the thermoelectric conversion materials, the materials of the conductive substrate, and the composition of the noble metals in the conductive paste. However, all of the thermoelectric conversion modules showed a smaller change in the maximum output, compared with the thermoelectric conversion module obtained in Comparative Example 2, and the change was almost the same as that of Example 88. These results confirm that bonding of the thermoelectric conversion materials to the silver sheets using the paste containing silver and platinum improves the durability in high-temperature air.

Table 2

| Ex | Composition of n-type thermoelectric conversion material | Composition of p-type thermoelectric conversion material | Number of pairs | Noble metal mixture | Mixed amount with respect to silver (wt%) | High-temperature-side electrode material | Low-temperature-side electrode material | High-temperature-side insulating substrate | Low-temperature-side insulating substrate | Maximum output (15 hours)/ Maximum output (0 hours) | Plating |
|---|---|---|---|---|---|---|---|---|---|---|---|
| 88 | $Mn_3Si_4Al_{2.3}$ | $MnSi_{1.75}$ | 14 | Platinum | 6 | Silver | Silver | Aluminum oxide | None | 0.996 | Nickel |
| 89 | $Mn_3Si_4Al_{2.3}$ | $MnSi_{1.75}$ | 14 | Platinum | 6 | Silver | Silver | Aluminum oxide | None | 0.979 | None |
| 90 | $Mn_3Si_4Al_{23}$ | $MnSi_{1.75}$ | 14 | Gold | 6 | Silver | Silver | Aluminum oxide | None | 0.993 | Nickel |
| 91 | $Mn_3Si_4Al_{2.3}$ | $MnSi_{1.75}$ | 14 | Palladium | 6 | Silver | Silver | Aluminum oxide | None | 0.981 | Nickel |
| 92 | $Mn_{2.7}Cr_{0.3}Si_4Al_{23}$ | $MnSi_{1.75}$ | 14 | Platinum | 0.5 | Silver | Silver | Aluminum oxide | None | 0.975 | Nickel |
| 93 | $Mn_{2.7}Cr_{0.3}Si_4Al_{23}$ | $MnSi_{1.75}$ | 14 | Platinum | 50 | Silver | Silver | Aluminum oxide | None | 0.973 | Nickel |
| 94 | $Mn_{2.7}Cr_{0.3}Si_4Al_{23}$ | $MnSi_{1.75}$ | 14 | Platinum | 95 | Silver | Silver | Aluminum oxide | None | 0.984 | Nickel |
| 95 | $Mn_{2.7}Cr_{0.3}Si_4Al_{23}$ | $MnSi_{1.75}$ | 64 | Platinum | 6 | Silver | Silver | Aluminum oxide | None | 0.990 | Nickel |
| 96 | $Mn_{2.7}Cr_{0.3}Si_4Al_2$ | $MnSi_{1.75}$ | 64 | Platinum | 6 | Silver | Silver | Aluminum oxide | None | 0.981 | Nickel |
| 97 | $Mn_{2.7}Cr_{0.3}Si_4Al_2$ | $MnSi_{1.75}$ | 64 | Platinum | 6 | Silver | Silver | None | None | 0.972 | Nickel |
| 98 | $Mn_{2.7}Cr_{0.3}Si_4Al_2$ | $MnSi_{1.75}$ | 64 | Platinum | 6 | Silver | Silver | Silicon nitride | Silicon nitride | 0.969 | Nickel |

**Claims**

**1.** A thermoelectric conversion element wherein one end of an n-type thermoelectric conversion material and one end of a p-type thermoelectric conversion material are each bonded to a conductive substrate using a bonding agent, wherein

(1) the n-type thermoelectric conversion material is a silicide of the following item (a) or (b):

(a) a silicide represented by the compositional formula:

$$Mn_{3-x1}M^1_{x1}Si_{y1}Al_{z1}M^2_{a1},$$

wherein $M^1$ is at least one element selected from the group consisting of Ti, V, Cr, Fe, Co, Ni, and Cu, $M^2$ is at least one element selected from the group consisting of B, P, Ga, Ge, Sn, and Bi,

$$0 \leq x1 \leq 3.0,$$

$$3.5 \leq y1 \leq 4.5,$$

$$2.0 \leq z1 \leq 3.5,$$

and

$$0 \leq a1 \leq 1,$$

the silicide having a negative Seebeck coefficient at a temperature of 25°C or higher; or

(b) a silicide represented by the compositional formula:

$$Mn_{x2}M^3_{y2}Si_{m2}Al_{n2},$$

wherein $M^3$ is at least one element selected from the group consisting of Ti, V, Cr, Fe, Co, Ni, and Cu,

$$2.0 \leq x2 \leq 3.5,$$

$$0 \leq y2 \leq 1.4,$$

$$2.5 \leq x2 + y2 \leq 3.5,$$

$$3.5 \leq m2 \leq 4.5,$$

and

$$1.5 \leq n2 \leq 2.49,$$

the silicide having a negative Seebeck coefficient at a temperature of 25°C or higher,

(2) the p-type thermoelectric conversion material is a silicide represented by the compositional formula: $Mn_{m3}M^4_{n3}Si_{p3}$, wherein $M^4$ is at least one element selected from the group consisting of Ti, V, Cr, Fe, Co, Ni, and Cu,

$$0.8 \leq m3 \leq 1.2,$$

$$0 \leq n3 \leq 0.4,$$

and

$$1.5 \leq p3 \leq 2.0,$$

the silicide having a positive Seebeck coefficient at a temperature of 25°C or higher, and
(3) the bonding agent is a conductive paste containing conductive metals consisting of silver and at least one noble metal selected from the group consisting of gold, platinum, and palladium.

**2.** The thermoelectric conversion element according to claim 1, wherein the conductive paste contains the at least one noble metal selected from the group consisting of gold, platinum, and palladium in a total amount of 0.5 to 95 parts by weight, per 100 parts by weight of silver.

**3.** The thermoelectric conversion element according to claim 1 or 2, wherein the conductive paste further contains a glass powder component, a resin component, and a solvent component.

**4.** The thermoelectric conversion element according to any one of claims 1 to 3, wherein the conductive substrate is a sheet-shaped conductive metal, a conductive ceramics, or an insulating ceramics on which a conductive metal coating is formed.

**5.** The thermoelectric conversion element according to claim 4, wherein the conductive substrate is a silver sheet having a thickness of 0.05 to 3 mm.

**6.** A thermoelectric conversion module comprising a plurality of the thermoelectric conversion elements of any one of claims 1 to 5, wherein the plurality of the thermoelectric conversion elements are connected in series in such a manner that an unconnected end of the p-type thermoelectric conversion material of one of the plurality of the thermoelectric conversion elements and an unconnected end of the n-type thermoelectric conversion material of another one of the plurality of the thermoelectric conversion elements are bonded to a conductive substrate using a bonding agent, and wherein the bonding agent is a conductive paste containing conductive metals consisting of silver and at least one noble metal selected from the group consisting of gold, platinum, and palladium.

**7.** The thermoelectric conversion module according to claim 6, wherein the conductive paste contains the at least one noble metal selected from the group consisting of gold, platinum, and palladium in a total amount of 0.5 to 95 parts by weight, per 100 parts by weight of silver.

**8.** The thermoelectric conversion module according to claim 6 or 7, wherein the conductive paste further contains a glass powder component, a resin component, and a solvent component.

**9.** The thermoelectric conversion module according to any one of claims 6 to 8, wherein the conductive substrate is a sheet-shaped conductive metal, a conductive ceramics, or an insulating ceramics on which a conductive metal coating is formed.

**10.** The thermoelectric conversion module according to claim 9, wherein the conductive substrate is a silver sheet having a thickness of 0.05 to 3 mm.

11. A thermoelectric conversion module comprising an electrically insulating substrate disposed on both sides or one side of the conductive substrates of the thermoelectric conversion module of any one of claims 6 to 10.

12. The thermoelectric conversion module according to claim 11, wherein the electrically insulating substrate is an oxide ceramics or a nitride ceramics.

13. A thermoelectric generation method comprising a step of positioning one side of the conductive substrates of the thermoelectric conversion module of any one of claims 6 to 11 at a high-temperature section, and the other side of the conductive substrates at a low-temperature section.

FIG. 1

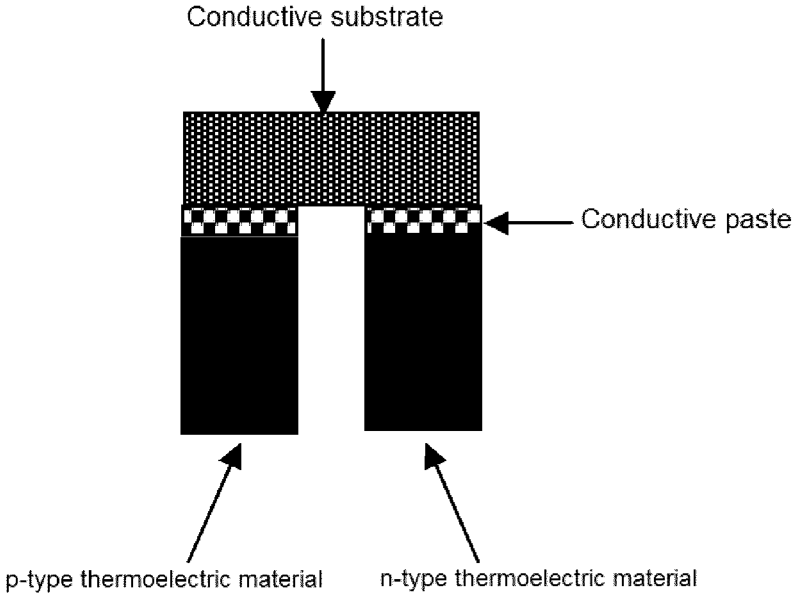
Conductive substrate
Conductive paste
p-type thermoelectric material
n-type thermoelectric material

FIG. 2

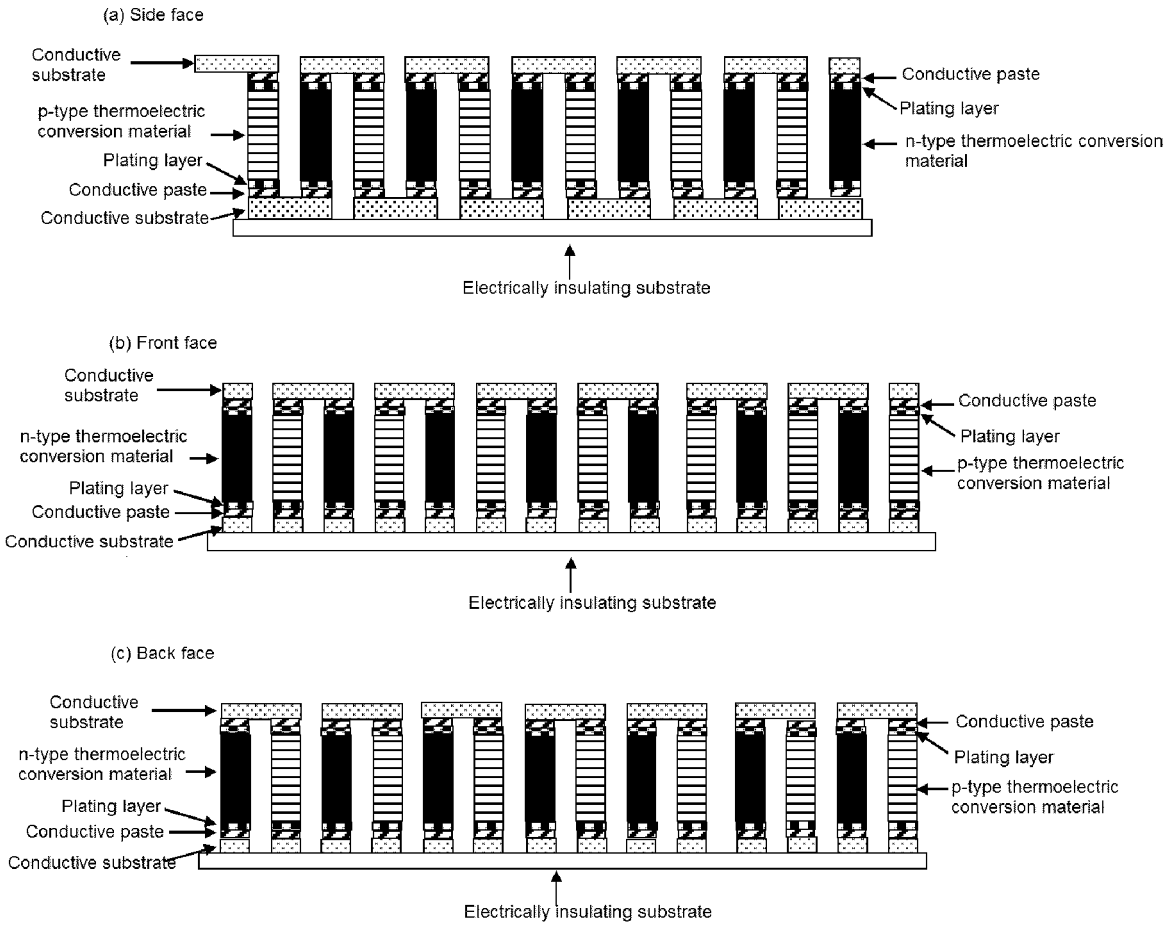
(a) Side face
Conductive substrate
p-type thermoelectric conversion material
Plating layer
Conductive paste
Conductive substrate
Conductive paste
Plating layer
n-type thermoelectric conversion material
Electrically insulating substrate
(b) Front face
Conductive substrate
n-type thermoelectric conversion material
Plating layer
Conductive paste
Conductive substrate
Conductive paste
Plating layer
p-type thermoelectric conversion material
Electrically insulating substrate
(c) Back face
Conductive substrate
n-type thermoelectric conversion material
Plating layer
Conductive paste
Conductive substrate
Conductive paste
Plating layer
p-type thermoelectric conversion material
Electrically insulating substrate

FIG. 3

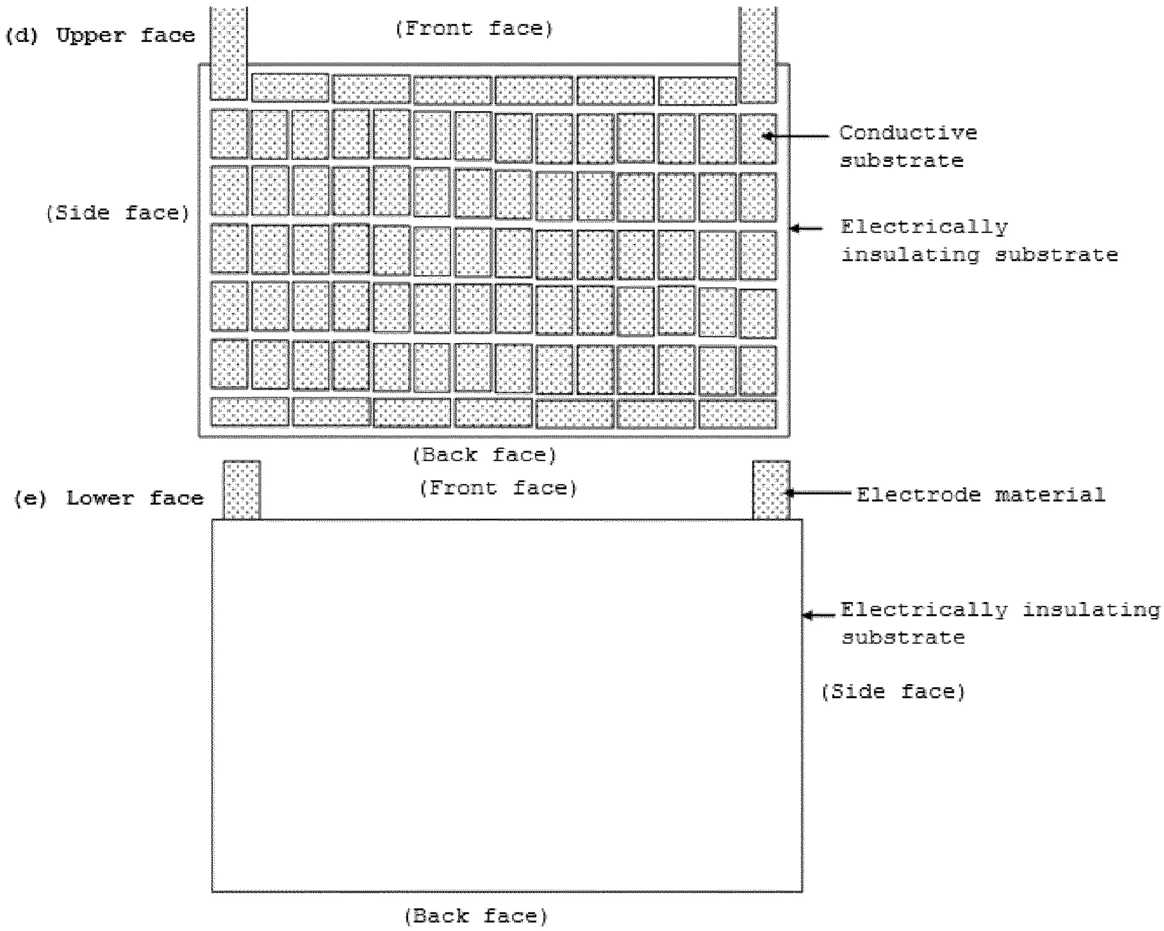
(d) Upper face
(Front face)
Conductive substrate
(Side face)
Electrically insulating substrate
(Back face)
(e) Lower face
(Front face)
Electrode material
Electrically insulating substrate
(Side face)
(Back face)

FIG. 4

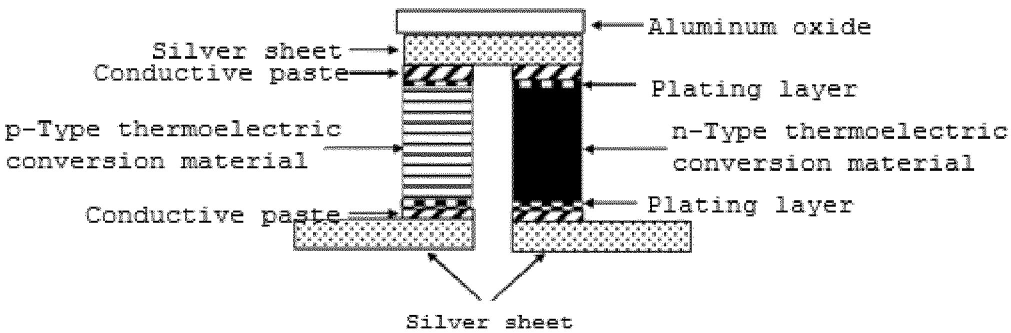
Aluminum oxide
Silver sheet
Conductive paste
Plating layer
p-Type thermoelectric conversion material
n-Type thermoelectric conversion material
Conductive paste
Plating layer
Silver sheet

FIG. 5

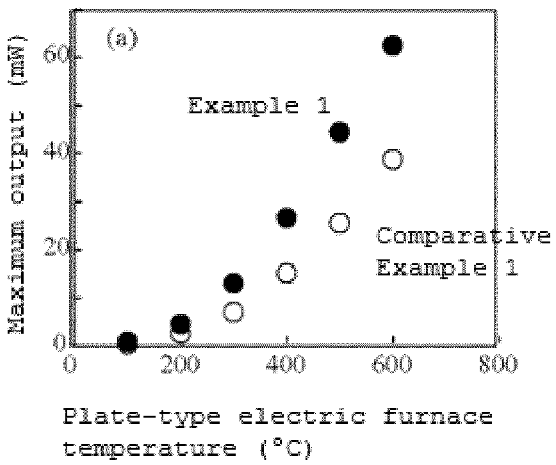
(a)
Maximum output (mW)
0
20
40
60
Example 1
Comparative Example 1
0
200
400
600
800
Plate-type electric furnace temperature (°C)

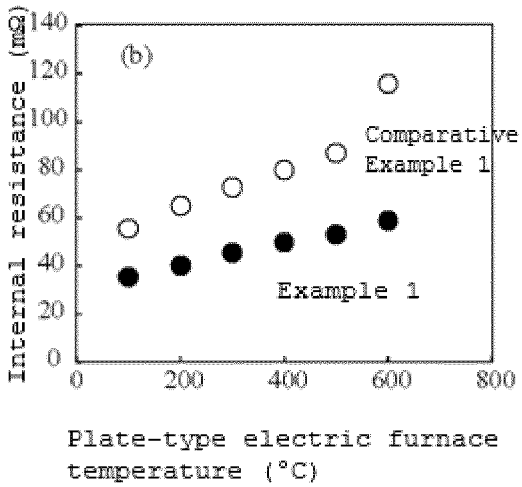
(b)
Internal resistance (mΩ)
0
20
40
60
80
100
120
140
Comparative Example 1
Example 1
0
200
400
600
800
Plate-type electric furnace temperature (°C)

FIG. 6

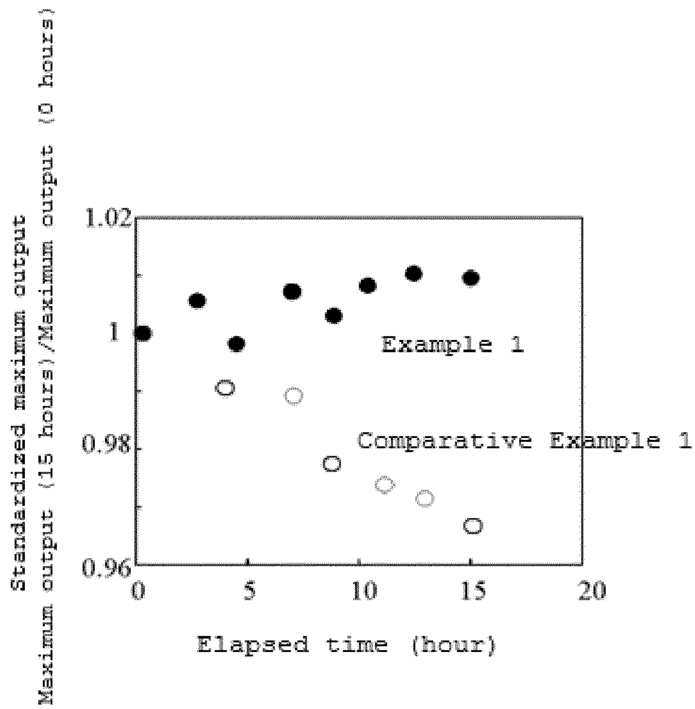
Standardized maximum output
Maximum output (15 hours)/Maximum output (0 hours)
0.96
0.98
1
1.02
Example 1
Comparative Example 1
0
5
10
15
20
Elapsed time (hour)

FIG. 7

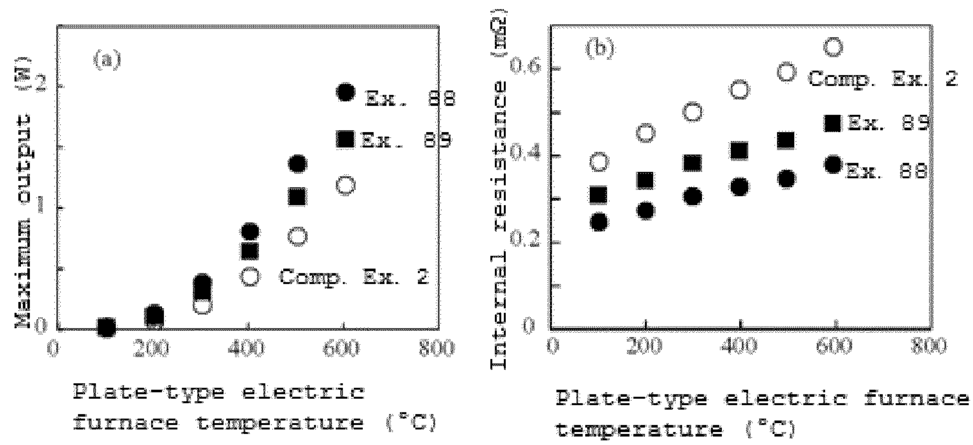
(a)
Maximum output (W)
Ex. 88
Ex. 89
Comp. Ex. 2
0
1
2
0
200
400
600
800
Plate-type electric furnace temperature (°C)
(b)
Internal resistance (mΩ)
Comp. Ex. 2
Ex. 89
Ex. 88
0
0.2
0.4
0.6
0
200
400
600
800
Plate-type electric furnace temperature (°C)

FIG. 8

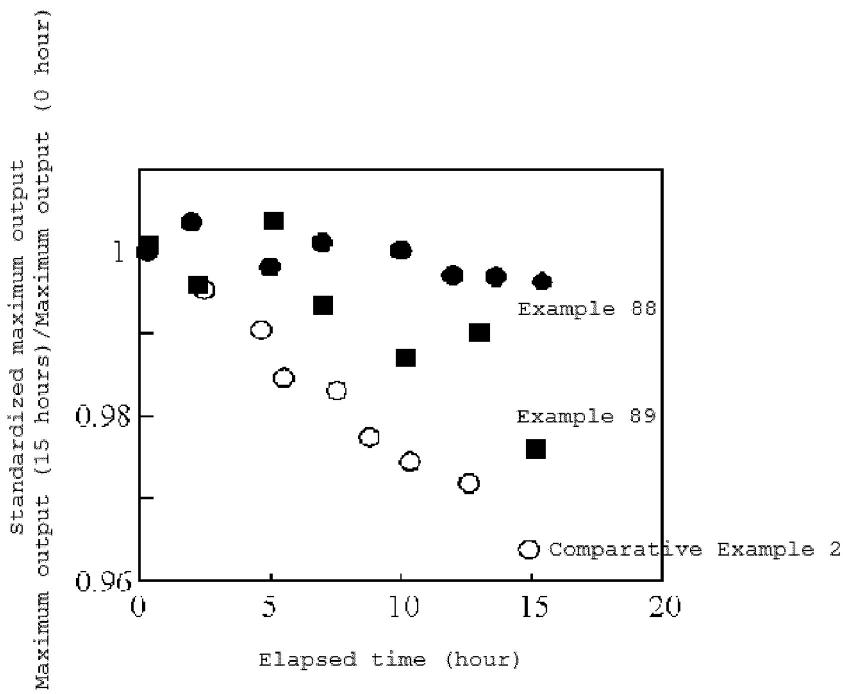
Standardized maximum output
Maximum output (15 hours)/Maximum output (0 hour)
1
0.98
0.96
0
5
10
15
20
Example 88
Example 89
Comparative Example 2
Elapsed time (hour)

## INTERNATIONAL SEARCH REPORT

International application No. PCT/JP2015/063791

**A. CLASSIFICATION OF SUBJECT MATTER**

*H01L35/08*(2006.01)i, *C22C5/06*(2006.01)i, *C22C29/18*(2006.01)i, *H01B1/22*(2006.01)i, *H01L35/14*(2006.01)i, *H01L35/34*(2006.01)i, *H02N11/00*(2006.01)i

According to International Patent Classification (IPC) or to both national classification and IPC

**B. FIELDS SEARCHED**

Minimum documentation searched (classification system followed by classification symbols)
H01L35/08, C22C5/06, C22C29/18, H01B1/22, H01L35/14, H01L35/34, H02N11/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2015 |
| Kokai Jitsuyo Shinan Koho | 1971-2015 | Toroku Jitsuyo Shinan Koho | 1994-2015 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2013-42862 A (National Institute of Advanced Industrial Science and Technology), 04 March 2013 (04.03.2013), paragraphs [0019] to [0042], [0073] to [0123]; fig. 2 to 3, 11 to 19 & WO 2013/027749 A1 | 1-13 |
| Y | JP 2014-49737 A (National Institute of Advanced Industrial Science and Technology), 17 March 2014 (17.03.2014), paragraphs [0014] to [0033], [0036] to [0050]; fig. 1 & WO 2014/038418 A1 | 1-13 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 14 July 2015 (14.07.15) | 28 July 2015 (28.07.15) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (July 2009)

**INTERNATIONAL SEARCH REPORT**

International application No. PCT/JP2015/063791

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2011-198831 A (Fujitsu Ltd.), 06 October 2011 (06.10.2011), paragraphs [0017] to [0033]; fig. 1 (Family: none) | 1-13 |
| Y | JP 4-246106 A (Tanaka Kikinzoku Kogyo Kabushiki Kaisha), 02 September 1992 (02.09.1992), paragraph [0002] (Family: none) | 1-13 |
| Y | CD-ROM of the specification and drawings annexed to the request of Japanese Utility Model Application No. 80902/1991(Laid-open No. 33547/1993) (Sanyo Electric Co., Ltd.), 30 April 1993 (30.04.1993), paragraphs [0009] to [0023]; fig. 1 (Family: none) | 1-13 |
| Y | JP 2013-229457 A (Mitsubishi Electric Corp.), 07 November 2013 (07.11.2013), paragraphs [0002] to [0004] (Family: none) | 1-13 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2012124243 A
- JP 2014049737 A


### Non-patent literature cited in the description


- **R. FUNAHASHI et al.** *Jpn. J. Appl. Phys.,* 2000, vol. 39, L1127
- **R. FUNAHASHI ; I. MATSUBARA ; S. SODEOKA.** Thermoelectric properties of Bi2Sr2Co2Ox polycrystalline materials. *Applied Physics Letters,* 2000, vol. 76 (17), 2385-2387
- **R. FUNAHASHI ; Y. MATSUMURA ; H. TANAKA ; T. TAKEUCHI ; W. NORIMATSU ; E. COMBE ; R.O. SUZUKI ; Y. WANG ; C. WAN ; S. KATSUYAMA.** Thermoelectric properties of n-type Mn3-xCrxSi4Al2 in air. *J. Appl. Phys.,* 2012, vol. 112, 073713
- **R. FUNAHASHI ; M. MIKAMI ; T. MIHARA ; S. URATA ; N. ANDO.** A portable thermoelectric-power-generating module composed of oxide devices. *Journal of Applied Physics,* 2006, vol. 99 (6), 066117